# EUROPEAN PATENT SPECIFICATION

(11) **EP 2 973 745 B1**
(45) Date of publication and mention of the grant of the patent: **28.04.2021**
(21) Application number: 14763163.4
(22) Date of filing: 12.03.2014
(51) Int. Cl.: H01L 31/0687, H01L 31/0693, H01L 31/18, H01L 31/043, H01L 31/0304

(54) **COMPOUND SEMICONDUCTOR PHOTOVOLTAIC CELL AND MANUFACTURING METHOD OF THE SAME**
FOTOVOLTAISCHE ZELLE MIT VERBUNDHALBLEITER UND HERSTELLUNGSVERFAHREN DAFÜR
CELLULE PHOTOVOLTAÏQUE À SEMI-CONDUCTEUR COMPOSÉ ET SON PROCÉDÉ DE FABRICATION

(30) Priority: 14.03.2013 JP 2013052519; 16.07.2013 JP 2013147485; 27.12.2013 JP 2013272522; 10.01.2014 JP 2014002832
(43) Date of publication of application: 20.01.2016
(73) Proprietor: Ricoh Company, Ltd., Tokyo 143-8555 (JP)
(72) Inventor: SATO, Shunichi, Tokyo 143-8555 (JP)
(74) Representative: J A Kemp LLP
(86) International application number: PCT/JP2014/057424
(87) International publication number: WO 2014/142340

(56) References cited:
- WO-A1-2012/074596
- WO-A1-2012/109448
- CN-A- 101 859 813
- CN-A- 102 184 980
- JP-A- 2010 186 822
- US-A1- 2007 131 275
- US-A1- 2007 131 275
- US-A1- 2008 190 479
- US-A1- 2012 125 392
- US-A1- 2012 138 116
- US-A1- 2012 152 340
- TANABE KATSUAKI ET AL: "Direct-bonded GaAs/InGaAs tandem solar cell", APPLIED PHYSICS LETTERS, AMERICAN INSTITUTE OF PHYSICS, 2 HUNTINGTON QUADRANGLE, MELVILLE, NY 11747, vol. 89, no. 10, 6 September 2006 (2006-09-06), pages 102106-102106, XP012085582, ISSN: 0003-6951, DOI: 10.1063/1.2347280
- JAIN R K ET AL: "Effect of InAlAs window layer on the efficiency of indium phosphide solar cells", PROCEEDINGS OF THE PHOTOVOLTAIC SPECIALISTS CONFERENCE. LAS VEGAS, OCT. 7 - 11, 19; [PROCEEDINGS OF THE PHOTOVOLTAIC SPECIALISTS CONFERENCE], NEW YORK, IEEE, US, vol. CONF. 22, 7 October 1991 (1991-10-07) , pages 341-346, XP010039190, DOI: 10.1109/PVSC.1991.169235 ISBN: 978-0-87942-636-1
- S. J. Chua ET AL: "Photoluminescence observations in band-gap tailored InGaAlAs epilayers lattice matched to InP substrate", Journal of Applied Physics, vol. 80, no. 8, 15 October 1996 (1996-10-15), pages 4604-4608, XP055462150, US ISSN: 0021-8979, DOI: 10.1063/1.363424
- MAKITA K. ET AL: "Advanced bonding method with conductive nanoparticle alignment for mechanically stacked multi-junction solar cells", PROCEEDINGS OF THE 27TH EUROPEAN PHOTOVOLTAIC SOLAR ENERGY CONFERENCE, 24 September 2012 (2012-09-24), - 28 September 2012 (2012-09-28), pages 78-80, XP040633696, ISBN: 978-3-936338-28-7

## Description

The present invention relates to a compound semiconductor photovoltaic cell and a method of manufacturing the compound semiconductor photovoltaic cell.

Compound semiconductors have different levels of band gap energy and lattice constants according to the material composition. Therefore, a multi-junction photovoltaic cell is produced, by which the wavelength range of sunlight is divided among a plurality of photovoltaic cells so that the energy conversion efficiency is increased.

Presently, a typical example of a multi-junction photovoltaic cell is a triplejunction photovoltaic cell (1.88 eV/1.40 eV/0.67 eV) including Ge cell/Ga(In)As cell/GaInP cell using a lattice matching material, provided on a germanium (Ge) substrate having substantially the same lattice constant as that of gallium arsenide (GaAs).

The efficiency of a photovoltaic cell made of a compound semiconductor is approximately two times as high as that of a silicon (Si) photovoltaic cell. However, a photovoltaic cell made of a compound semiconductor has a high-cost substrate or a smallsized substrate, and is thus significantly more expensive than a silicon photovoltaic cell. Accordingly, a photovoltaic cell made of a compound semiconductor is used for special purposes, mainly for space use in such as a space satellite.

Furthermore, recently, a concentrated photovoltaic cell has been formed by combining an inexpensive condensing lens made of plastic and a small cell of a photovoltaic cell made of a compound semiconductor. Accordingly, the usage amount of an expensive compound semiconductor is reduced compared to a typical flat plate photovoltaic cell formed without using a condensing lens. Such a concentrated photovoltaic cell can be manufactured at a lower cost and is used practically as a photovoltaic cell for general purposes other than special purposes as described above.

However, the power generation cost of a photovoltaic cell still remains high, and therefore it is imperative to further reduce the cost. Thus, studies are being conducted to increase the energy conversion efficiency and to reduce the manufacturing cost.

However, the band gap balance of a lattice-matched-type triple-junction photovoltaic cell, which is mainly used now, using a Ge substrate is not optimal from a viewpoint of a current balance. It is desired to increase the band gap of the bottom cell in the configuration thereof.

As an example configuration for obtaining a higher efficiency, there is a triple-junction photovoltaic cell in which the band gaps of the cells are set to 1.9 eV/1.42 eV/1.0 eV (for example, Non-Patent document 1).

As the materials of the cells having band gaps of 1.9 eV and 1.42 eV, GaInP and GaAs, respectively, which are in lattice matching with GaAs substrate, are used. On the other hand, as the material of the cell having band gap of 1.0 eV, a GaInAs cell, which is not in lattice matching with a GaAs substrate and causes a lattice mismatching amount of approximately 2%, is used. To achieve this structure, crystal is grown in the direction opposite to the growing direction of crystal of usual photovoltaic cells.

Specifically, a GaInP cell and a GaAs cell are sequentially grown on a GaAs substrate. Next, a GaInAs cell is grown via a lattice relaxation buffer layer which is for changing a lattice constant difference. Then, the surface is adhered to a supporting substrate. Finally, by removing the GaAs substrate, the triple-junction photovoltaic cell is produced. Light is incident on the side of the GaInP cell having a greater band gap.

Further, there is a mechanical stack type photovoltaic cell in which a GaAs substrate having a GaAs top cell is deposited on an InP substrate having a GaInAsP bottom cell (for example, Patent Document 1). Those cells are not directly connected to each other physically in the light receiving region, but the cells are mechanically connected to each other, so that the cells are optically connected via the gap.

Further, there is a photovoltaic cell using a conductive nanoparticle array based on a direct bonding (see, for example, Non-Patent Document 2), in which a GaAs substrate having a photovoltaic cell formed thereon and an InP substrate are connected via a Palladium (Pd) nanoparticle array based on a Van-der-Waals (VDW) method, so that a current flows via an ohmic contact between the nanoparticles and the semiconductor.

Further, there is a photovoltaic cell formed by directly bonding a GaAs substrate having a GaInP top cell formed thereon and an InP substrate having a GaInAs bottom cell formed thereon (see, for example, Patent Document 2).

Further, there is a photovoltaic cell formed by directly bonding a surface of a GaAs substrate having a GaAs cell formed thereon and a surface of an InP substrate having a GaInAs bottom cell formed thereon (Non-Patent Document 3). It becomes possible to easily form a cell in the short-wavelength region on the GaAs substrate using a lattice matching material and form a cell in the long-wavelength region on the InP substrate using a lattice matching material.

However, the triple-junction photovoltaic cell disclosed in Non-Patent Document 1 has a structure including a lattice-relaxation buffer layer, between the GaAs cell and the GaInAs cell, where defects (dislocations) are concentrated due to lattice relaxation. Such a layer including the defects becomes a cause of rebonding before sunlight is absorbed and generated carriers are acquired from an electrode. As a result, it becomes difficult to obtain high efficiency.

Further, the defects may be increased during the operation and thereby degrading the efficiency over time. Therefore, it is difficult to produce a photovoltaic cell having high reliability.

Further, in the photovoltaic cell disclosed in Patent Document 1, in the light receiving region, long-wavelength light, which is transmitted from the GaAs substrate having a GaAs cell, is incident onto a GaInAsP cell formed on the InP substrate.

In such a structure, an InP window layer having a smaller band gap than the GaAs has is formed on the light incident side of the GaInAsP cell. Therefore, before light is incident onto the GaInAsP cell, a part of the light is absorbed by the InP window layer. Such an InP window layer may become a cause of degradation of the efficiency.

Further, in the photovoltaic cell disclosed in Non-Patent Document 2, the long-wavelength light transmitted through the GaInPAs cell (1.8 eV) is incident onto the GaInPAs cell (1.15 eV). However, on the light incident side of the GaInPAs cell (1.15 eV), an InP bonding layer having a smaller band gap than the absorbing layer of the GaInPAs cell is formed under the GaInPAs cell (1.8 eV) via a Pd layer.

Due to this structure, before light is incident onto the GaInPAs cell (1.15 eV), a part of the light is absorbed by the InP bonding layer. The InP bonding layer has a function as a bonding layer and a function as a window layer. However, due to smaller long-wavelength light transmitted through the GaAs cell is incident onto the GaInPAs cell. However, the InP bonding layer having a smaller band gap than GaAs is formed on the light incident side of the GaInAs cell as a bonding layer directly connecting a GaAs epitaxial substrate. Due to the InP bonding layer, before light is incident onto the GaInAs cell, a part of the light is absorbed by the InP bonding layer. Such an InP bonding layer is a cause of the degradation of efficiency of the photovoltaic cell.

Further, in the related technologies disclosed in Non-Patent Document 2, the long-wavelength light transmitted through the GaInP cell is incident onto the GaInAs cell. However, the InP bonding layer having a smaller band gap than GaInP is formed on the light incident side of the GaInAs cell as a bonding layer directly connecting a GaAs epitaxial substrate. Due to the InP bonding layer, before light is incident onto the GaInAs cell, a part of the light is absorbed by the InP bonding layer. Such an InP window layer is a cause of the degradation of efficiency of the photovoltaic cell.

CN101859813 discloses a method of making a four-junction GaInP / GaAs / InGaAs / Ge solar cells using a wafer bonding method, based on inverted structures grown GaInP / GaAs / InGaAs and Ge triplejunction solar cells monolithically integrated sun, make full use of Ge cell, either directly as a four-junction cells of the bottom cell, and as a supporting substrate, to achieve four knot band gap energy was 1.9 / 1.4 / 1.0 / 0.67eV solar cell, to a greater extent to achieve full-spectrum sunlight absorption and energy conversion, so you can get more than 45% conversion efficiency. The present invention reduces the mechanical cascade solar cell system using a plurality of different substrates resulting in high costs and complicated optical integrated battery optical system and optical losses, but also an effective solution to the growth of the monolithic four cascade semiconductor junction solar battery material lattice mismatch problem. High voltage, low current output, reducing resistance in the high-power condenser battery consumption.

US20070131275 discloses methods and apparatuses for creating solar cell assemblies with bonded interlayers. In summary, the present invention describes an apparatus and method for making a solar cell assembly with transparent conductive bonding interlayers. An apparatus in accordance with the present invention comprises a substrate, a first solar cell, coupled to a first side of the substrate, wherein the first solar cell comprises a first Transparent Conductive Coating (TCC) layer coupled to a first polarity electrode of the first solar cell, and a second solar cell, the second solar cell being bonded to the first solar cell by bonding the first TCC layer to the second solar cell.

US2008190479 discloses an optoelectronical semiconductor device having a bonding structure comprises a first optoelectronical structure, a second optoelectronical structure, and a transparent bonding structure formed in-between.

CN 102 184 980 A (SUZHOU INST NANO TECH & NANO B) 14 September 2011 (2011-09-14), discloses background information.

MAKITA K. ET AL: "Advanced bonding method with conductive nanoparticle alignment for mechanically stacked multi-junction solar cells", PROCEEDINGS OF THE 27TH EUROPEAN PHOTO-VOLTAIC SOLAR ENERGY CONFERENCE, 24 September 2012 (2012-09-24), - 28 September 2012 (2012-09-28), pages 78-80, XP040633696, ISBN: 978-3-936338-28-7, discloses background information.

As described above, in a compound semiconductor photovoltaic cell of the related technologies, efficiency has not been sufficiently improved.

The present invention is made in light of the problem and may provide a compound semiconductor photovoltaic cell having higher efficiency and a manufacturing method of the compound semiconductor photovoltaic cell.

According to an embodiment, there is provided a compound semiconductor photovoltaic cell as defined in the appended claims.

According to an embodiment of the present invention, it may become possible to provide a compound semiconductor photovoltaic cell having higher efficiency and a manufacturing method of the compound semiconductor photovoltaic cell. The present invention is defined in independent product claims 1 and 2.

### BRIEF DESCRIPTION OF THE DRAWINGS

FIG. 1 is a cross-sectional view of a compound semiconductor photovoltaic cell 100 according to a first embodiment, not being part of the present invention;
FIGS. 2A and 2B illustrate a manufacturing method of the compound semiconductor photovoltaic cell 100 according to the first embodiment;
FIGS. 3A and 3B illustrate the manufacturing method of the compound cell 100 according to a first embodiment;

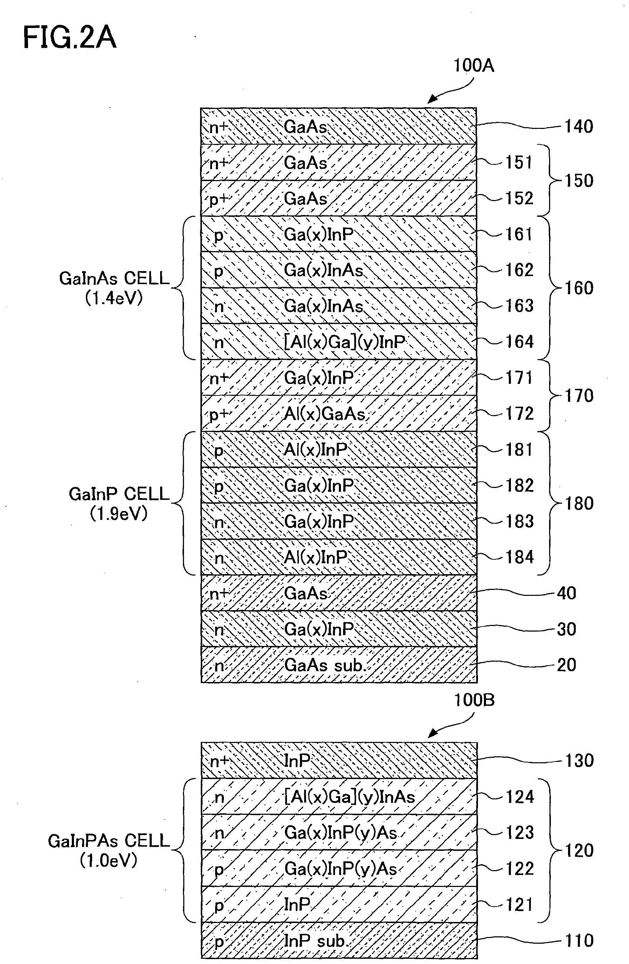

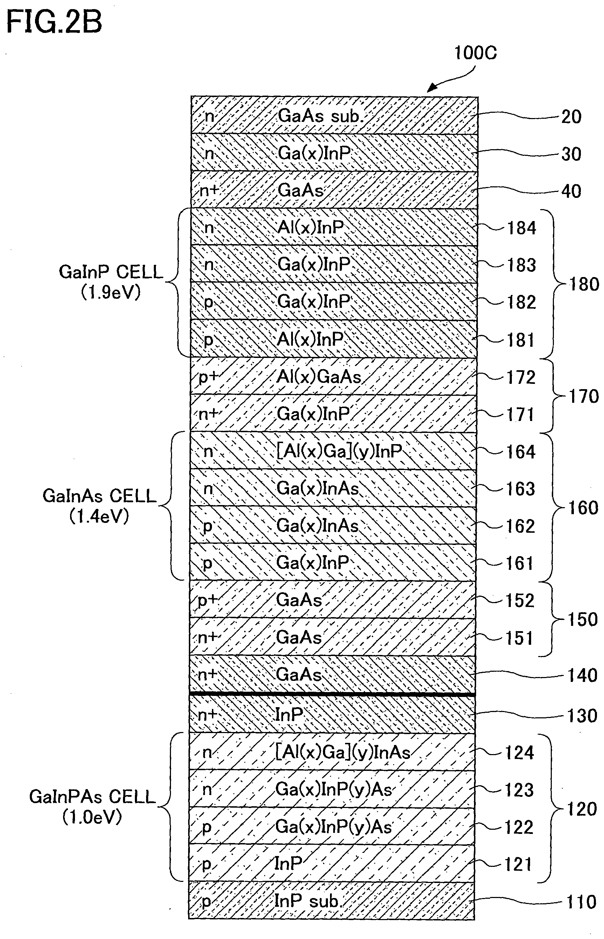

FIGS. 2A and 2B illustrate a manufacturing method of the compound semiconductor photovoltaic cell 100 according to the first embodiment;

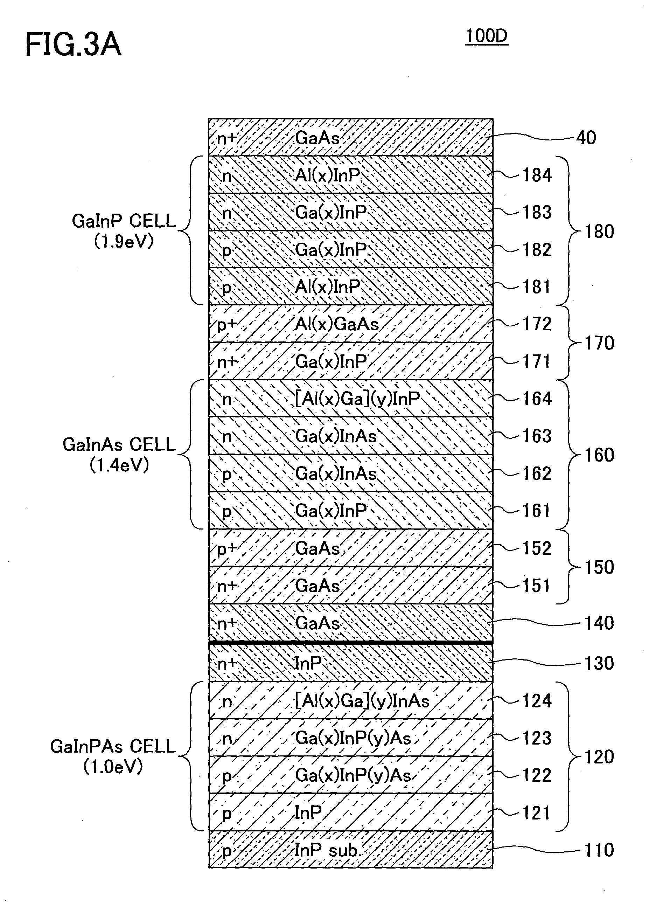

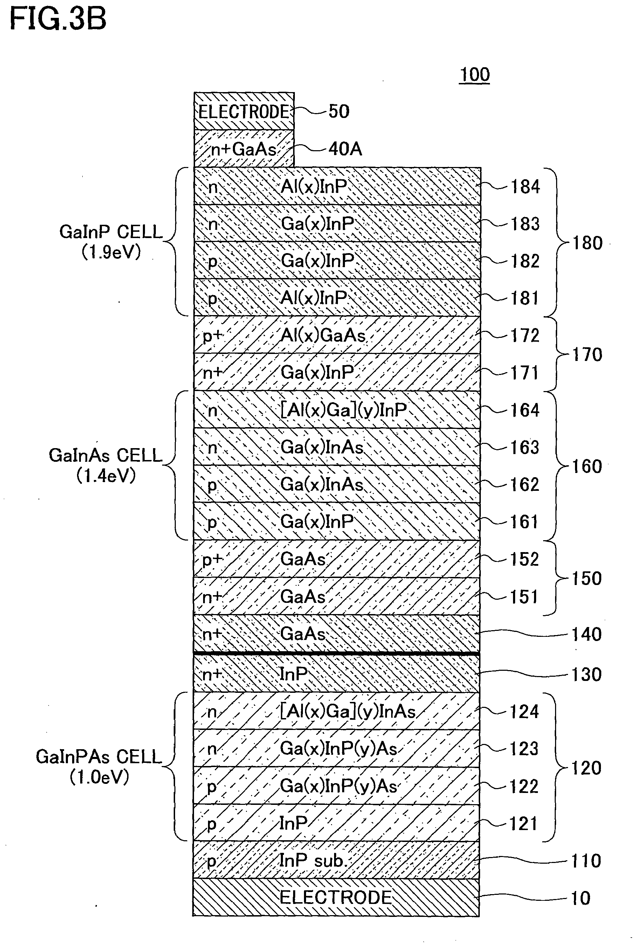

FIGS. 3A and 3B illustrate the manufacturing method of the compound semiconductor photovoltaic cell 100 according to the first embodiment;

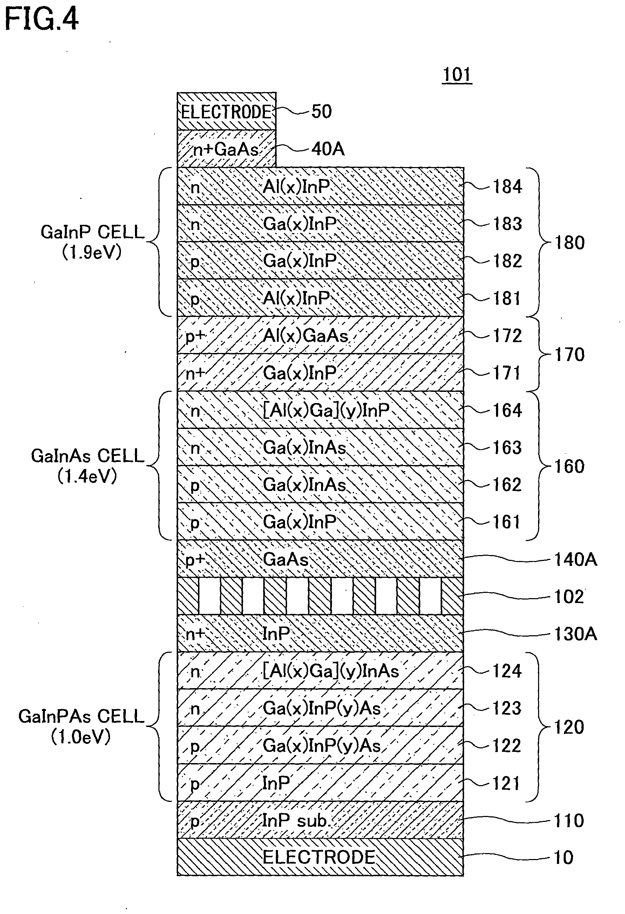

FIG. 4 is a cross-sectional view of a compound semiconductor photovoltaic cell 101 according to a first modified example of the first embodiment;

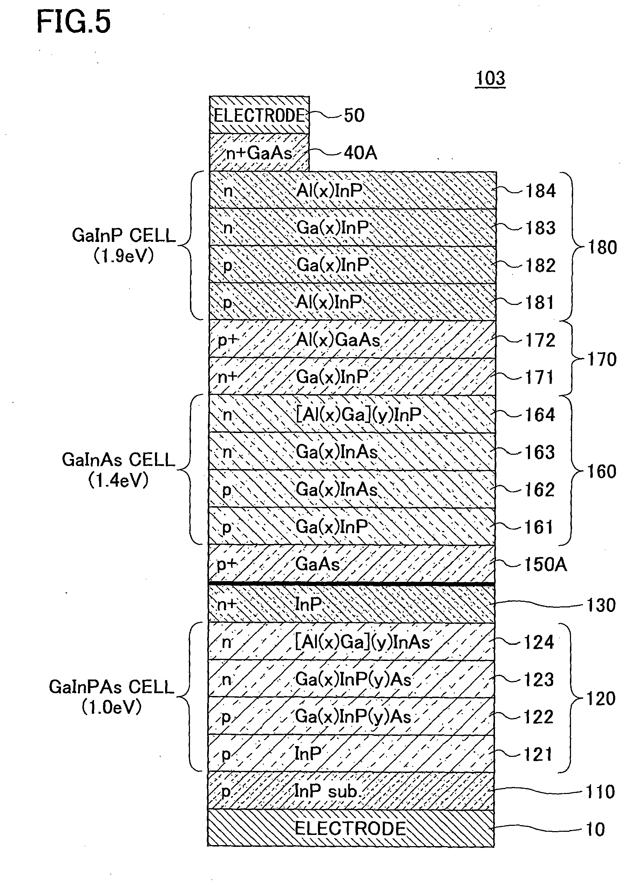

FIG. 5 is a cross-sectional view of a compound semiconductor photovoltaic cell 103 according to a second modified example of the first embodiment;

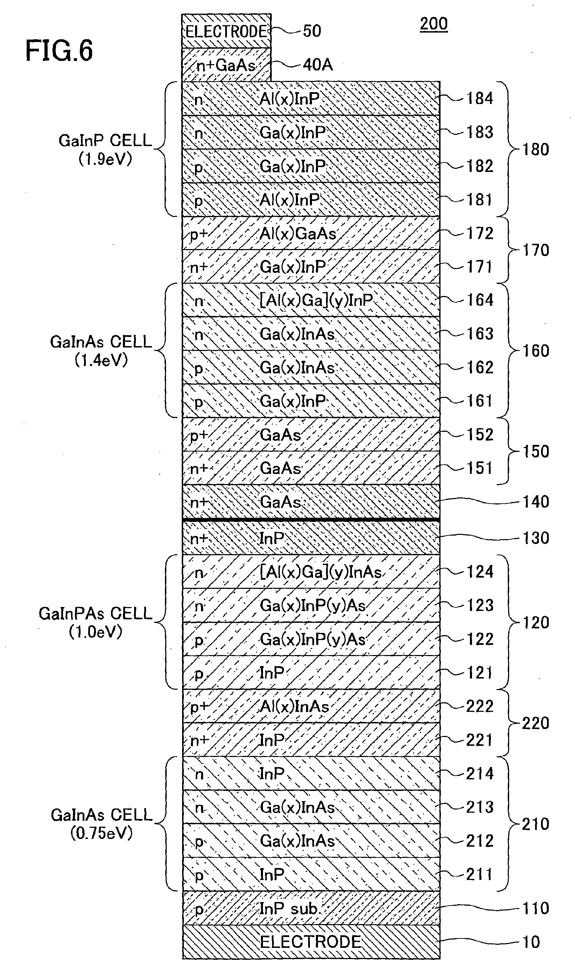

FIG. 6 is a cross-sectional view of a compound semiconductor photovoltaic cell 200 according to a second embodiment, not being part of the present invention;

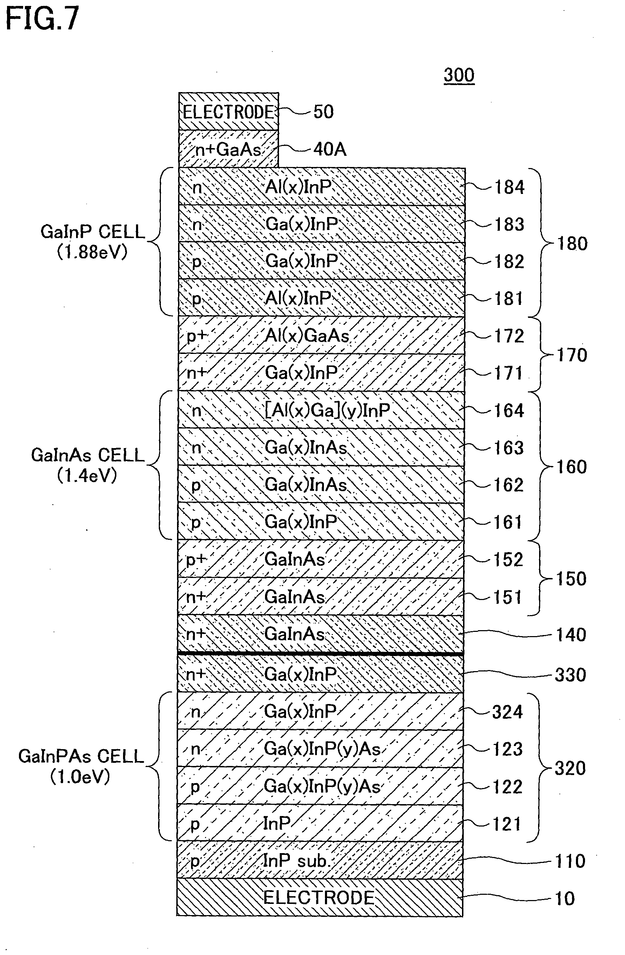

FIG. 7 is a cross-sectional view of a compound semiconductor photovoltaic cell 200 according to a third embodiment;

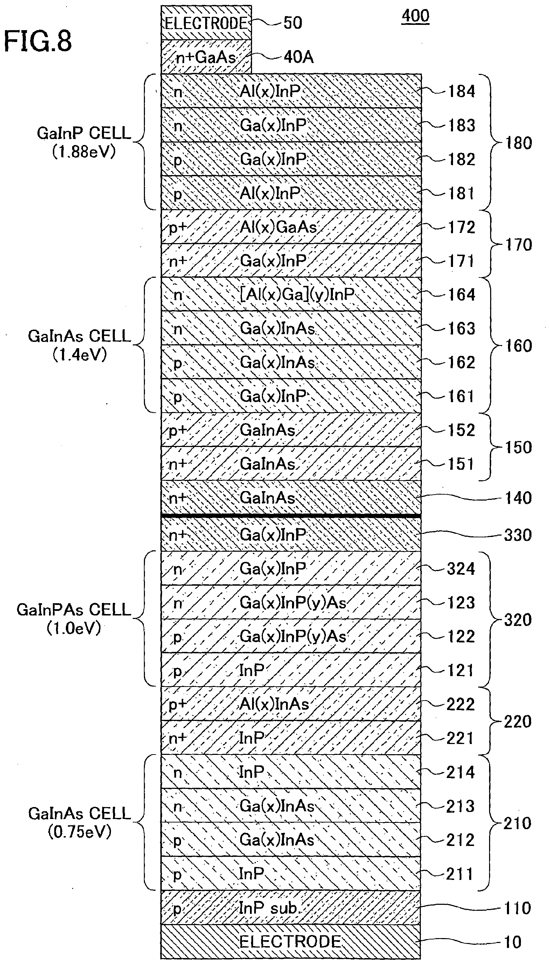

FIG. 8 is a cross-sectional view of a compound semiconductor photovoltaic cell 200 according to a fourth embodiment;

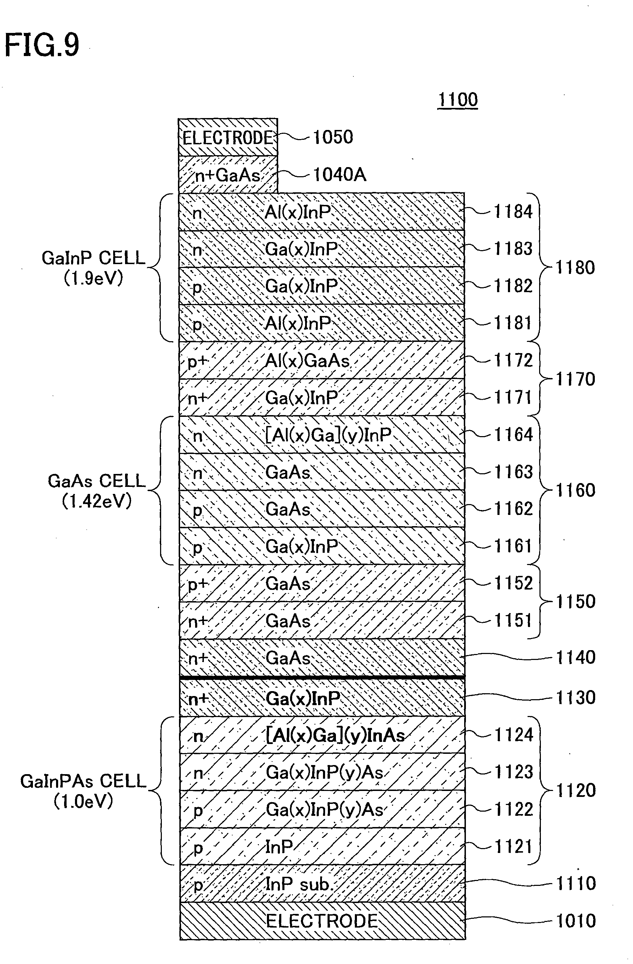

FIG. 9 is a cross-sectional view of a compound semiconductor photovoltaic cell 500 according to a fifth embodiment;

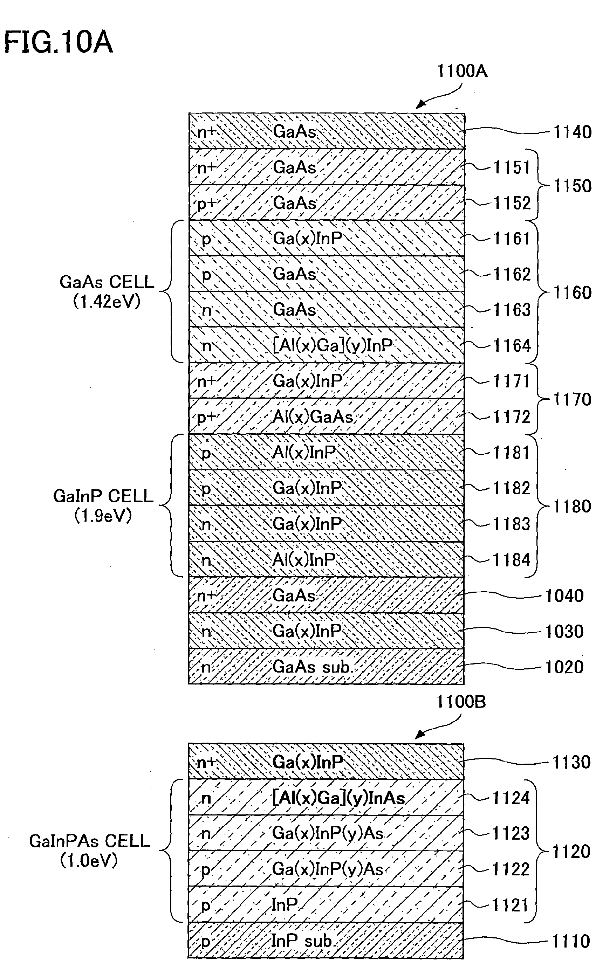

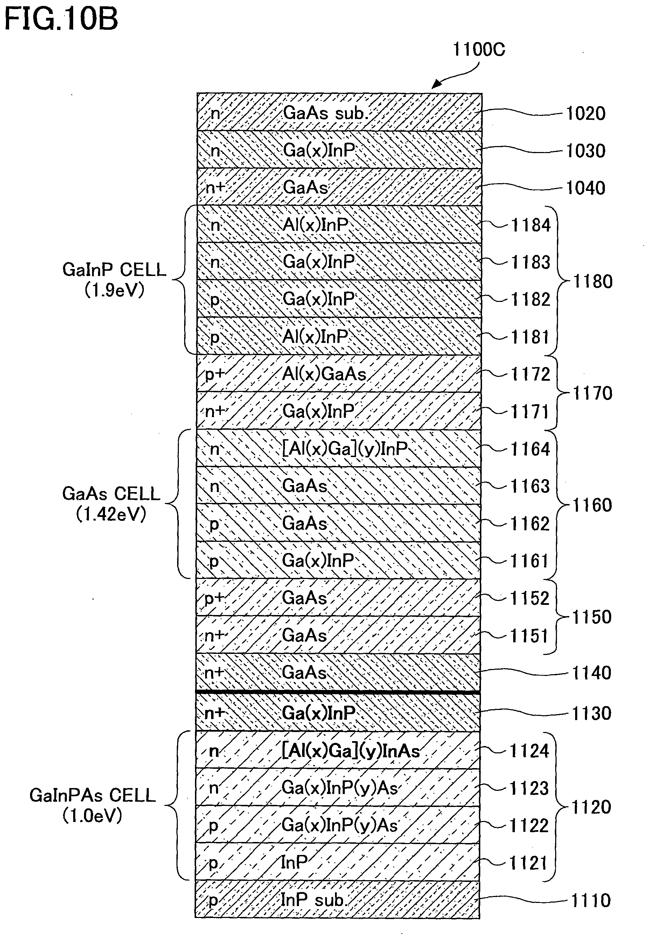

FIGS. 10A and 10B illustrate a manufacturing method of the compound semiconductor photovoltaic cell 500 according to the fifth embodiment;

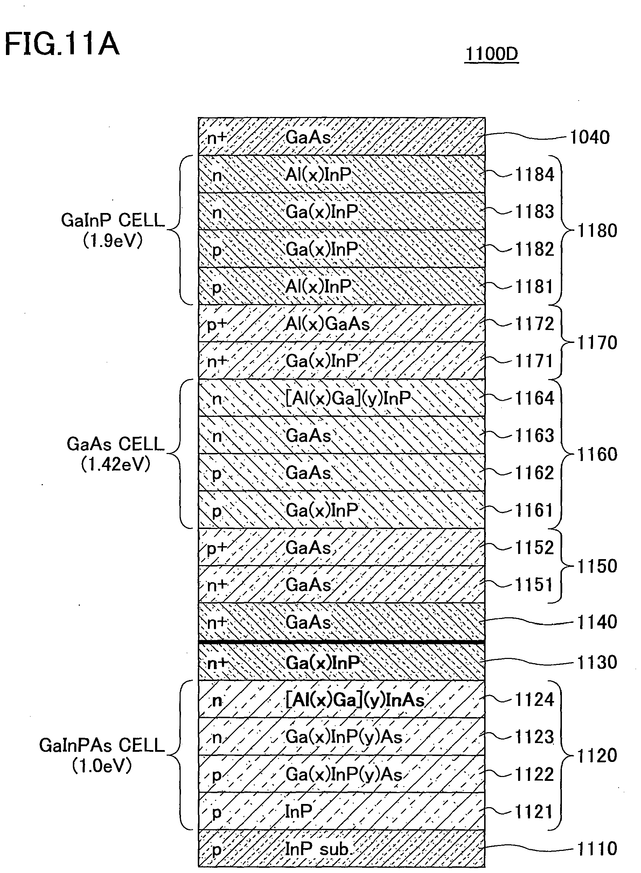

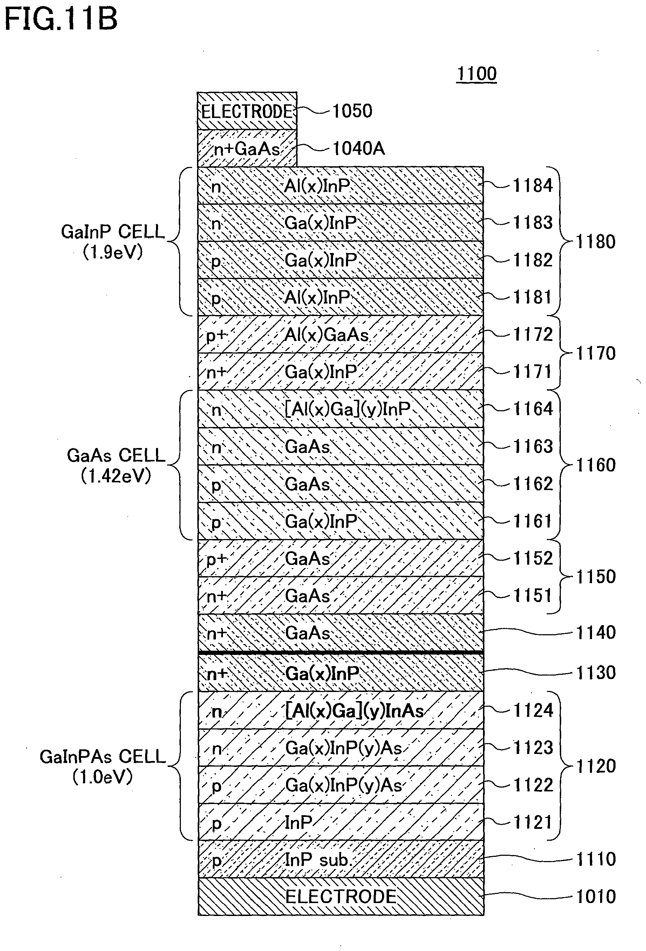

FIGS. 11A and 11B illustrate the manufacturing method of the compound semiconductor photovoltaic cell 500 according to the fifth embodiment;

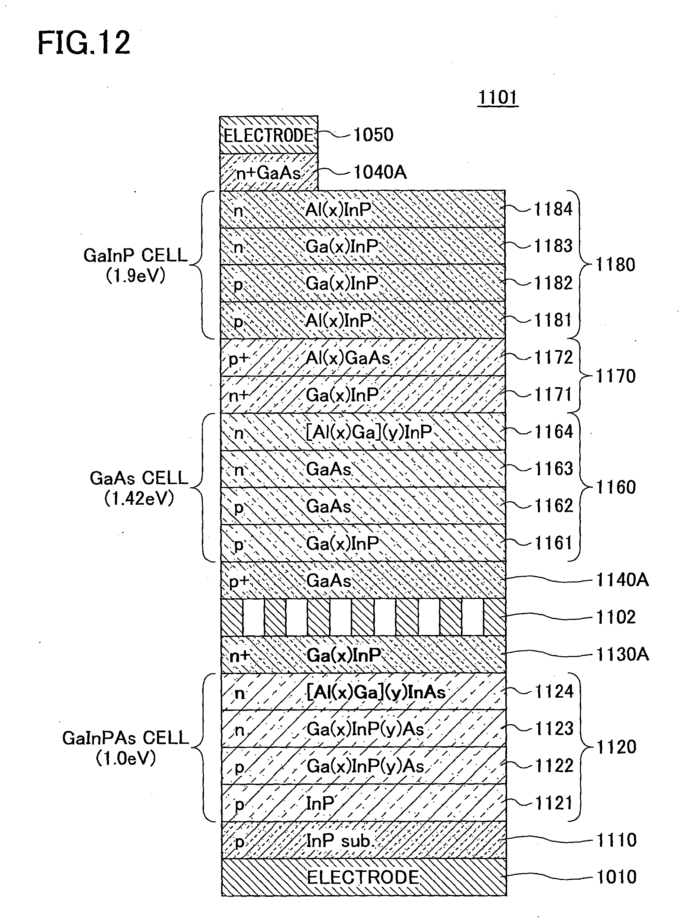

FIG. 12 is a cross-sectional view of a compound semiconductor photovoltaic cell 501 according to a first modified example of the fifth embodiment;

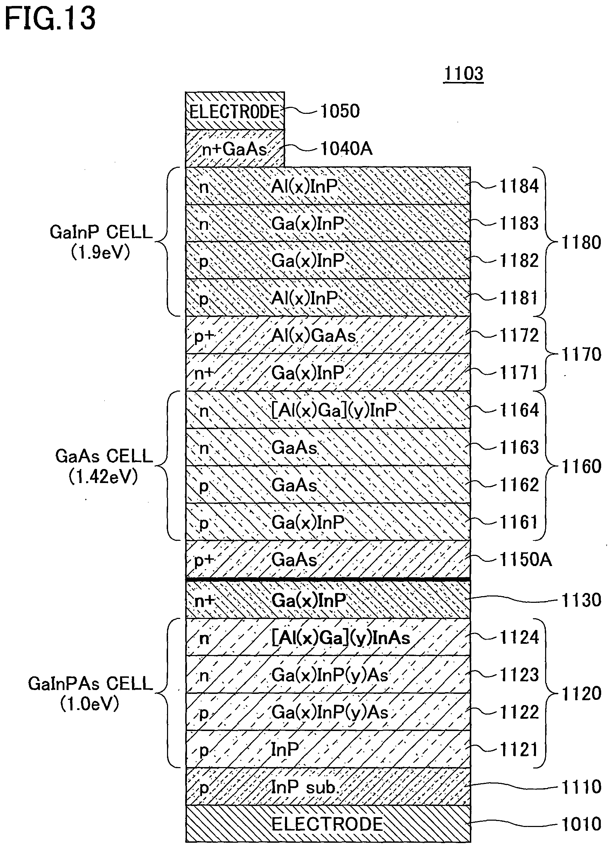

FIG. 13 is a cross-sectional view of a compound semiconductor photovoltaic cell 503 according to a second modified example of the fifth embodiment;

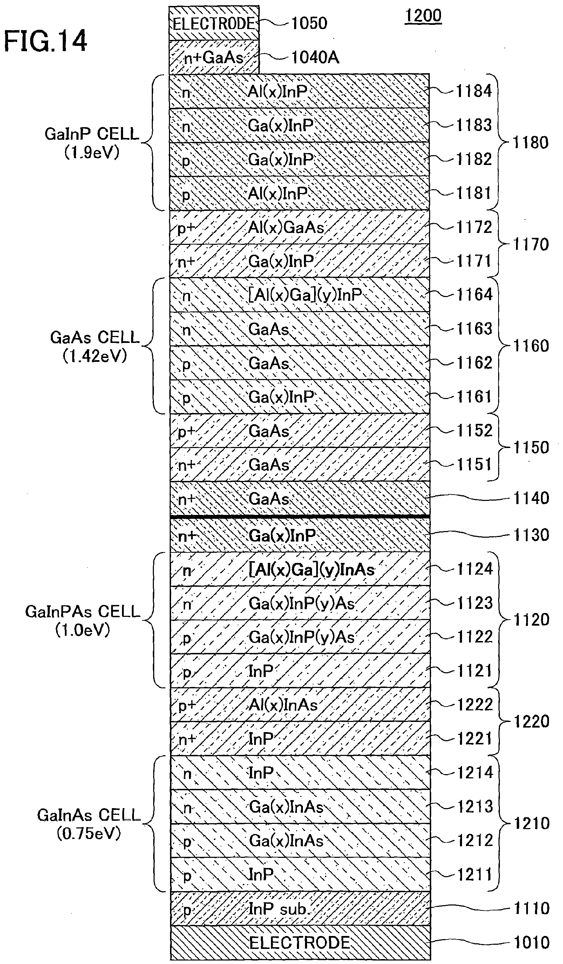

FIG. 14 is a cross-sectional view of a compound semiconductor photovoltaic cell 600 according to a sixth embodiment;

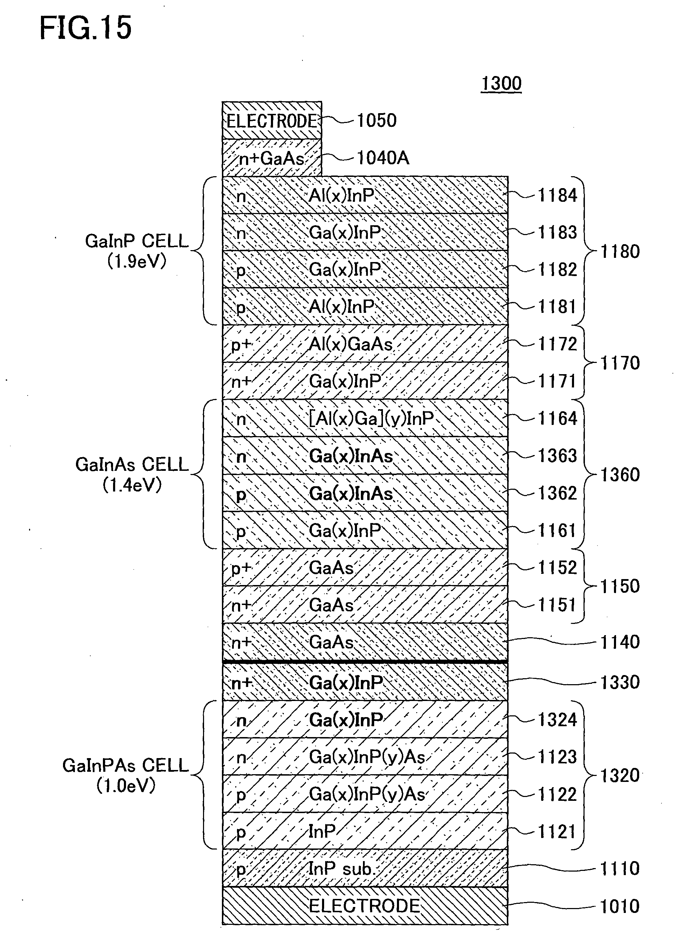

FIG. 15 is a cross-sectional view of a compound semiconductor photovoltaic cell 700 according to a seventh embodiment; and

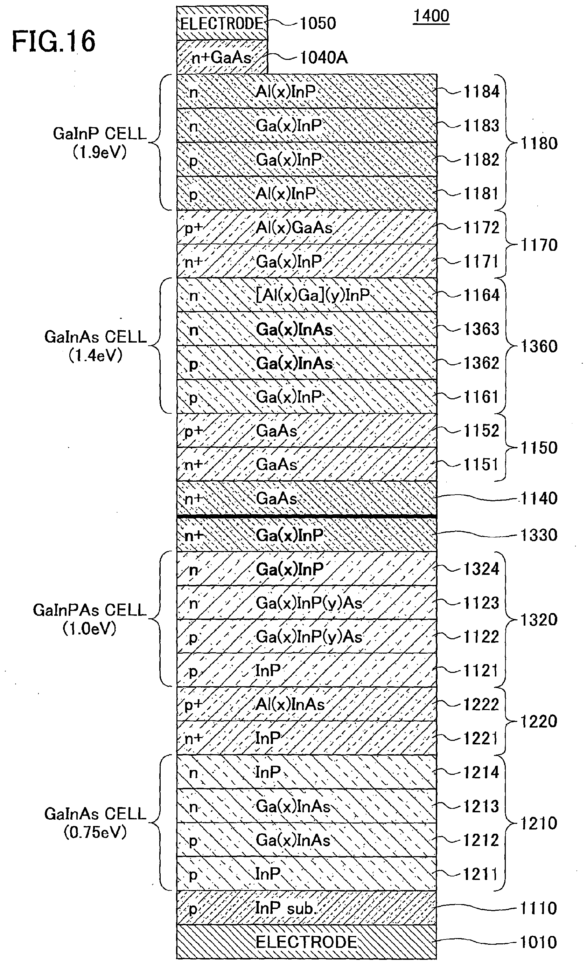

FIG. 16 is a cross-sectional view of a compound semiconductor photovoltaic cell 800 according to an eighth embodiment;

In the following, compound semiconductor photovoltaic cells and manufacturing method of the compound semiconductor photovoltaic cells according to embodiments of the present disclosure are described.

### First embodiment, not being part of the present invention:

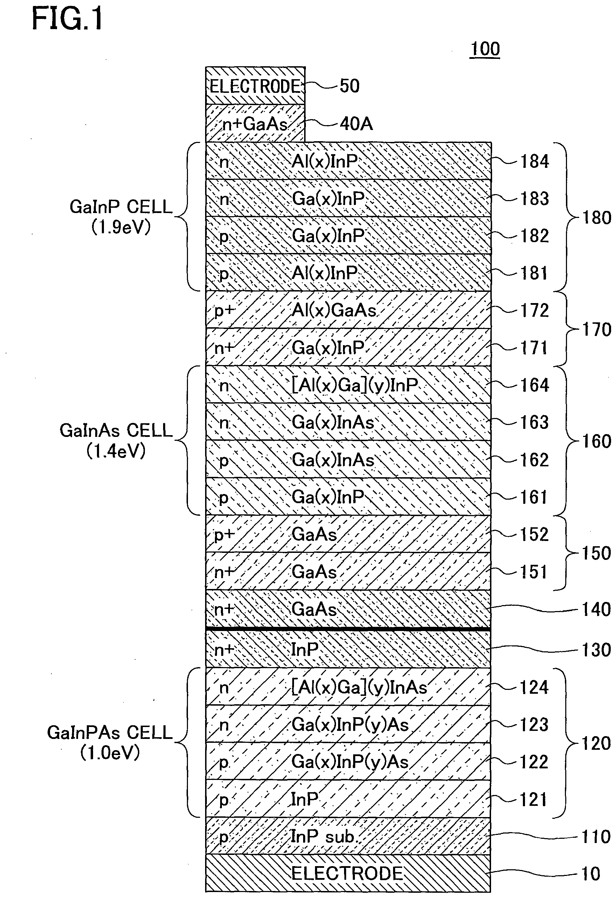

FIG. 1 is a cross-sectional view of a compound semiconductor photovoltaic cell 100 according to a first embodiment, not being part of the present invention;

The compound semiconductor photovoltaic cell 100 includes an electrode 10, an InP substrate 110, a GaInPAs cell 120, a bonding layer 130, a bonding layer 140, a tunnel junction layer 150, a GaInAs cell 160, a tunnel junction layer 170, a GaInP cell 180, a contact layer 40A, and an electrode 50.

The compound semiconductor photovoltaic cell 100 according to the first embodiment is a triple-junction photovoltaic cell in which the GaInPAs cell 120 (1.0 eV), the GaInAs cell 160 (1.40 eV), and the GaInP cell 180 (1.9 eV) are connected in series.

As the cells included in the compound semiconductor photovoltaic cell 100, there are an Indium Phosphorus (InP) based photoelectric conversion cell and a Gallium Arsenic (GaAs) based photoelectric conversion cell. The InP based photoelectric conversion cell refers to a photoelectric conversion cell which is formed of a material system that is substantially in lattice matching with InP and can be crystal grown on the InP substrate 110. Here, the material that is substantially in lattice matching with InP and can be crystal grown on the InP substrate 110 is called an "InP lattice matching based material". Further, the cell formed of the "InP lattice matching based material" is called an "InP lattice matching based material cell".

On the other hand, the GaAs based photoelectric conversion cell refers to a photoelectric conversion cell which is formed of a material system that is substantially in lattice matching with GaAs or Germanium (Ge) which has a lattice constant substantially equal to that of GaAs and can be crystal grown on a GaAs substrate or a Ge substrate. Here, the material that is substantially in lattice matching with GaAs or Ge which has a lattice constant substantially equal to that of GaAs and can be crystal grown on a GaAs substrate or a Ge substrate is called a "GaAs lattice matching based material". Further, the cell formed of the "GaAs lattice matching based material" is called a "GaAs lattice matching based material cell".

Those terms are similarly used in second through fourth embodiments as well.

In the compound semiconductor photovoltaic cell 100, the GaInPAs cell 120 is the InP based photoelectric conversion cell and the GaInAs cell 160 and the GaInP cell 180 are the GaAs based photoelectric conversion cell.

Here, the InP substrate 110 is an example of a compound semiconductor substrate or a first compound semiconductor substrate. The GaInPAs cell 120 is an example of a first photoelectric conversion cell which is made of a first compound semiconductor material.

The bonding layer 130 is an example of a bonding layer that is made of a second compound semiconductor material and is deposited on the GaInPAs cell 120. The GaInAs cell 160 and the GaInP cell 180 are examples of a plurality of second photoelectric conversion cells which are made of a third compound semiconductor material.

In FIG. 1, light is incident in the direction from the upper side to the lower side in the figure (i.e., in the direction from the GaInP cell 180 to the GaInPAs cell 120) (hereinafter the "light incident direction").

The electrode 10 is an electrode serving as a lower electrode disposed on the back (deeper) side in the light incident direction. As the electrode 10, an electrode, which is formed by stacking metal layers made of, for example Ti/Pt/Au, may be used.

As the InP substrate 110, a wafer, which is made of, for example, p-type single-crystal indium phosphorus, may be used. As an impurity, for example, Zn may be used.

The GaInPAs cell 120 is formed on a surface of the InP substrate 110. The GaInPAs cell 120 includes a p-type InP layer 121, a p-type Ga(x)InP(y)As layer 122, a n-type Ga(x)InP(y)As layer 123, and a n-type [Al(x)Ga](y)InAs layer 124.

The GaInPAs cell 120 includes crystal layers of GaInPAs which is in lattice matching with InP. The InP layer 121, the Ga(x)InP(y)As layer 122, the Ga(x)InP(y)As layer 123, and the [Al(x)Ga](y)InAs layer 124 are deposited in this order on the surface of the InP substrate 110.

The InP layer 121 is a Back Surface Field (BSF) layer disposed on the back side in the light incident direction. The pn junction of the GaInPAs cell 120 is formed between the Ga(x)InP(y)As layer 122 and the Ga(x)InP(y)As layer 123. The [Al(x)Ga](y)InAs layer 124 is a window layer disposed on the front side (light incident side) in the light incident direction.

Here, the GaInPAs cell 120 may be regarded as a cell having the Ga(x)InP(y)As layer 122 and the Ga(x)InP(y)As layer 123, which form the pn junction, the [Al(x)Ga](y)InAs layer 124 formed on the light incident side of the GaInPAs cell 120, and the InP layer 121 formed on the back side in the light incident direction.

The InP layer 121 is used as the BSF layer, and therefore the InP layer 121 has a band gap greater than the band gap (1.0 eV) of the p-type Ga(x)InP(y)As layer 122 and the n-type Ga(x)InP(y)As layer 123. As an impurity of the InP layer 121, Zinc (Zn) may be used.

The conductive type of the Ga(x)InP(y)As layer 122 becomes p-type by using, for example, Zn as an impurity.

The conductive type of the Ga(x)InP(y)As layer 123 becomes n-type by using, for example, Si as an impurity.

In the Ga(x)InP(y)As layer 122 and the Ga(x)InP(y)As layer 123, the rate "x" of Ga and the rate "y" of P are adjusted so that the band gap the layers is 1.0 eV.

The [Al(x)Ga](y)InAs layer 124 is used as a window layer. Therefore, the [Al(x)Ga](y)InAs layer 124 has a band gap greater than the band gap (1.0 eV) of the Ga(x)InP(y)As layer 122 and the Ga(x)InP(y)As layer 123. In the first embodiment, the band gap of the [Al(x)Ga](y)InAs layer 124 is set to, for example, 1.5 eV.

In order to ensure the light transmitted through the bonding layer 130 reaches the Ga(x)InP(y)As layer 122 and the Ga(x)InP(y)As layer 123 of the GaInPAs cell 120, the band gap of the [Al(x)Ga](y)InAs layer 124, which is the window layer of the GaInPAs cell 120, is set to, for example, 1.5 eV.

In this case, similar to a compound semiconductor photovoltaic cell in related technologies, if an InP layer is used as the window layer 124, a part of sunlight transmitted through the GaInAs cell 160 (1.40 eV) is absorbed because the band gap of InP is 1.35 eV.

In the compound semiconductor photovoltaic cell 100 according to the first embodiment, in order to prevent the occurrence of such energy loss, the [Al(x)Ga](y)InAs layer 124 having the band gap greater than that of the GaInAs cell 160 is used as the window layer.

As the impurity of the [Al(x)Ga](y)InAs layer 124, for example, Si may be used.

AlGaInAs is in lattice matching with InP and therefore is suitable for depositing the Ga(x)InP(y)As layer 123.

The bonding layer 130 is bonded to the bonding layer 140 by a cleaning process and a surface activation process in a step of manufacturing the compound semiconductor photovoltaic cell 100. The compound semiconductor photovoltaic cell 100 is manufactured by bonding two layered bodies.

The bonding layer 130 is formed on the uppermost surface of one of the two layered bodies, and the bonding layer 140 is formed on the uppermost surface of the other layered body. Then, the bonding layer 130 and the bonding layer 140 are bonded to each other to form the compound semiconductor photovoltaic cell 100.

As the bonding layer 130, an n+type InP layer is used. The impurity concentration of the bonding layer 130 is set to be greater than that of the [Al(x)Ga](y)InAs layer 124. By so doing, the conductive type of the bonding layer 130 is an n+type.

The band gap of the InP layer used as the bonding layer 130 is 1.35 eV, which is less than that of the GaInAs cell 160, so that a part of the light transmitted through the GaInAs cell 160 is absorbed. However, this is preferable because the absorbed amount in this case is less than that in a case where a GaAs cell is used in the related technology as described in Non-Patent Document 3.

Herein, a case is described where the band gap of the InP layer used as the bonding layer 130 is 1.35 eV. However, the band gap may be greater than 1.35 eV by using a Ga(x)InP layer, to which Ga is added, as the bonding layer 130 and increasing the composition ratio of Ga.

In this case, it is preferable that the material to be used as the bonding layer 130 have a band gap greater than or equal to the band gap (1.40 eV) of the GaInAs cell 160 which is disposed on the light incident side (upstream side) of the bonding layer 130.

Further, between the bonding layer 130 and the GaInAs cell 160, the bonding layer 140 and the tunnel junction layer 150 are formed. Both the bonding layer 140 and the tunnel junction layer 150 include GaAs so as to have a band gap of 1.42 eV. Therefore, the light transmitted through the GaInAs cell 160 is not absorbed.

The bonding layer 140 is bonded to the bonding layer 130, which is disposed on the InP substrate 110 side thereof, by a cleaning process and a surface activation process in a step of manufacturing the compound semiconductor photovoltaic cell 100. As the bonding layer 140, for example, an n+type GaAs layer may be used. The band gap of the GaAs layer is 1.42 eV, which is greater than that of the GaInAs cell 160. Therefore, the GaAs layer does not absorb the light transmitted through the GaInAs cell 160. The impurity concentration of the bonding layer 140 is set to be similar to that of the bonding layer 130.

In the compound semiconductor photovoltaic cell 100 of FIG. 1, the upper side of the boundary between the bonding layer 130 and the bonding layer 140 is formed by sequentially depositing layers in, for example, an upside-down state. Therefore, the bonding layer 140 is deposited on the tunnel junction layer 150.

The tunnel junction layer 150 is formed between the bonding layer 140 and the GaInAs cell 160. In the compound semiconductor photovoltaic cell 100 of FIG. 1, the upper side of the boundary between the bonding layer 130 and the bonding layer 140 is formed by sequentially depositing layers in, for example, an upside-down state. Therefore, the tunnel junction layer 150 is deposited on the GaInAs cell 160.

The tunnel junction layer 150 includes an n+type GaAs layer 151 and a p+type GaAs layer 152. As the impurity to set the conductive type to n-type, for example, tellurium (Te) may be used. As the impurity to set the conductive type to p-type, for example, carbon (C) may be used. The n+type GaAs layer 151 and the p+type GaAs layer 152 include a thin pn junction doped in high concentration.

The GaAs layer 151 and the GaAs layer 152 of the tunnel junction layer 150 are doped with higher concentration than the GaInAs cell 160. The tunnel junction layer 150 is a junction layer which is formed in order to flow current between a p-type GaInAs layer 162 of the GaInAs cell 160 and the n-type Ga(x)InP(y)As layer 123 of the GaInPAs cell 120 (by tunnel junction).

The GaInAs cell 160 is formed between the tunnel junction layer 150 and the tunnel junction layer 170.

The GaInAs cell 160 includes a p-type Ga(x)InP layer 161, a p-type GaInAs layer 162, an n-type GaInAs layer 163, and an n-type [Al(x)Ga](y)InP layer 164.

The Ga(x)InP layer 161, the GaInAs layer 162, the GaInAs layer 163, and the [Al(x)Ga](y)InP layer 164 are deposited in this order on the surface of the tunnel junction layer 150. In an actual manufacturing process, the GaInAs cell 160 is deposited on the tunnel junction layer 170 in, for example, the upside-down state.

Therefore, in an actual manufacturing process, for example, the [Al(x)Ga](y)InP layer 164, the GaInAs layer 163, the GaInAs layer 162, and the Ga(x)InP layer 161 are deposited in this order on the tunnel junction layer 170.

The Ga(x)InP layer 161 is a Back Surface Field (BSF) layer disposed on the back side in the light incident direction. The pn junction of the GaInAs cell 160 is included in the GaInAs layer 162 and the GaInAs layer 163. The [Al(x)Ga](y)InP layer 164 is a window layer disposed on the front side (light incident side) in the light incident direction.

Here, the GaInAs cell 160 may be regarded as a cell having the GaInAs layer 162 and the GaInAs layer 163, which form the pn junction, the [Al(x)Ga](y)InP layer 164 formed on the light incident side of the GaInPAs cell 120, and the Ga(x)InP layer 161 formed on the back side in the light incident direction.

The Ga(x)InP layer 161 is used as the BSF layer, and therefore the Ga(x)InP layer 161 has a band gap greater than the band gap (1.40 eV) of the p-type GaInAs layer 162 and the n-type GaInAs layer 163. As impurity of the Ga(x)InP layer 161, for example, Zn may be used.

The conductive type of the GaInAs layer 162 becomes p-type by using, for example, Zn as impurity.

The conductive type of the GaInAs layer 163 becomes n-type by using, for example, Si as an impurity.

The band gap of the GaInAs layer 162 and the GaInAs layer 163 is 1.40 eV.

The [Al(x)Ga](y)InP layer 164 is used as a window layer. Therefore, the [Al(x)Ga](y)InP layer 164 has a band gap greater than the band gap (1.40 eV) of the p-type GaInAs layer 162 and the n-type GaInAs layer 163.

In the first embodiment, the [Al(x)Ga](y)InP layer 164 has a band gap greater than the band gap (1.40 eV) of the p-type GaInAs layer 162 and the n-type GaInAs layer 163. As an impurity of the [Al(x)Ga](y)InP layer 164, for example, Si may be used.

The tunnel junction layer 170 is formed between the GaInAs cell 160 and the GaInP cell 180. The upper side of the boundary between the bonding layer 130 and the bonding layer 140 in the compound semiconductor photovoltaic cell 100 of FIG. 1 is formed by sequentially depositing layers in, for example, an upside-down state. Therefore, the tunnel junction layer 170 is deposited on the GaInP cell 180.

The tunnel junction layer 170 includes an n-type Ga(x)InP layer 171 and a p-type Al(x)GaAs layer 172. As an impurity to set the conductive type to n-type, for example, tellurium (Te) may be used. As the impurity to set the conductive type to p-type, for example, carbon (C) may be used. The n-type Ga(x)InP layer 171 and the p-type Al(x)GaAs layer 172 include a thin pn junction doped in high concentration.

The n-type Ga(x)InP layer 171 and the p-type Al(x)GaAs layer 172 of the tunnel junction layer 170 are doped with higher concentration than the GaInP cell 180. The tunnel junction layer 170 is a junction layer which is formed in order to flow current between a p-type Ga(x)InP layer 182 of the GaInP cell 180 and the n-type GaInAs layer 163 of the GaInAs cell 160 (by tunnel junction).

The GaInP cell 180 is formed between the tunnel junction layer 170 and the contact layer 40A.

The GaInP cell 180 includes a p-type Al(x)InP layer 181, a p-type Ga(x)InP layer 182, an n-type Ga(x)InP layer 183, and an n-type Al(x)InP layer 184.

The Al(x)InP layer 181, the p-type Ga(x)InP layer 182, the n-type Ga(x)InP layer 183, and the n-type Al(x)InP layer 184 are deposited in this order on the surface of the tunnel junction layer 170. In an actual manufacturing process, the GaInP cell 180 is deposited on the GaAs contact layer 40A on a GaAs substrate (not shown) in, for example, the upside-down state.

The GaInP cell 180 includes crystal layers of GaInP which are in lattice matching with GaAs. In an actual manufacturing process, for example, the Al(x)InP layer 184, the Ga(x)InP layer 183, the Ga(x)InP layer 182, and the Al(x)InP layer 181 are deposited in this order.

The Al(x)InP layer 181 is a Back Surface Field (BSF) layer disposed on the back side in the light incident direction. The pn junction of the GaInP cell 180 is included in the Ga(x)InP layer 182 and the Ga(x)InP layer 183. The Al(x)InP layer 184 is a window layer disposed on the front side (light incident side) in the light incident direction.

Here, the GaInP cell 180 may be regarded as a cell having the Ga(x)InP layer 182 and the Ga(x)InP layer 183, which form the pn junction, the Al(x)InP layer 184 formed on the light incident side of the GaInP cell 180, and the Al(x)InP layer 181 formed on the back side in the light incident direction.

The Al(x)InP layer 181 is used as the BSF layer, and therefore the Al(x)InP layer 181 has a band gap greater than the band gap (1.9 eV) of the p-type Ga(x)InP layer 182 and the n-type Ga(x)InP layer 183. As an impurity of the Al(x)InP layer 181, for example, Zn may be used.

The conductive type of the Ga(x)InP layer 182 becomes p-type by using, for example, Zn as an impurity.

The conductive type of the Ga(x)InP layer 183 becomes n-type by using, for example, Si as an impurity.

The band gap of the Ga(x)InP layer 182 and the Ga(x)InP layer 183 is 1.9 eV. The Al(x)InP layer 184 is used as a window layer. Therefore, the Al(x)InP layer 184 has a band gap greater than the band gap (1.9 eV) of the p-type Ga(x)InP layer 182 and the n-type Ga(x)InP layer 183.

In the first embodiment, the Al(x)InP layer 184 has a band gap greater than the band gap (1.9 eV) of the p-type Ga(x)InP layer 182 and the n-type Ga(x)InP layer 183. As an impurity of the Al(x)InP layer 184, for example, Si may be used.

The contact layer 40A is a layer that is deposited on the GaInP cell 180 to form ohmic contact with the electrode 50. As the contact layer 40A, for example, a gallium arsenide (GaAs) layer is used.

The electrode 50 is a thin film made of a metal such as, for example, Ti/Pt/Au, and is formed on the contact layer 40A.

Next, a method of manufacturing the compound semiconductor photovoltaic cell 100 according to the first embodiment is described with reference to FIGS. 2A through 3B.

FIGS. 2A through 3B illustrate a method of manufacturing the compound semiconductor photovoltaic cell 100 according to the first embodiment.

As shown in FIG. 2A, a layered body 100A is formed by using a GaAs substrate 20 and a layered body 100B is formed by using the InP substrate 110. The GaAs substrate 20 is an example of a second compound semiconductor substrate.

Here, the GaInP cell 180 included in the layered body 100A includes crystal layers of GaInP which is in lattice matching with GaAs, and is formed on the GaAs substrate 20. Further, the GaInPAs cell 120 included in the layered body 100B includes crystal layers of GaInPAs which is in lattice matching with InP and is formed on the InP substrate 110.

As described above, the lattice constant of the layered body 100A differs from that of the layered body 100B. The compound semiconductor photovoltaic cell 100 according to the first embodiment is manufactured by directly bonding the layered body 100A to the layered body 100B having a lattice constant different from that of the layered body 100A.

The lattice constant of InP is approximately 5.87 Å. Therefore, the composition of the GaInPAs cell 120 formed on the InP substrate 110 is adjusted in a manner such that the GaInPAs cell 120 has a lattice constant very close to the lattice constant of InP (approximately 5.87 Å).

Further, the lattice constant of GaAs is approximately 5.65 Å. Therefore, the composition of the GaInAs cell 160 and the GaInP cell 180 formed on the GaAs substrate 20 is adjusted in a manner such that the GaInAs cell 160 and the GaInP cell 180 have the lattice constants very close to the lattice constant of InP (approximately 5.65 Å).

The layered body 100A is formed by depositing a Ga(x)InP etching stop layer 30, an n+type GaAs contact layer 40, the GaInP cell 180, the tunnel junction layer 170, the GaInAs cell 160, the tunnel junction layer 150, and the bonding layer 140 on the GaAs substrate 20 by Metal Organic Chemical Vapor Deposition (MOCVD) method.

Here, the GaInP cell 180 includes the Al(x)InP layer 184 which is in lattice matching with GaAs, the Ga(x)InP layer 183, the Ga(x)InP layer 182, and the Al(x)InP layer 181. The Al(x)InP layer 181 is a BSF layer, and the Al(x)InP layer 184 is a window layer.

The tunnel junction layer 170 includes the Al(x)GaAs layer 172 and the Ga(x)InP layer 171.

The GaInAs cell 160 includes the [Al(x)Ga](y)InP layer 164, the GaInAs layer 163, the GaInAs layer 162, and the Ga(x)InP layer 161. The Ga(x)InP layer 161 is a BSF layer, and the [Al(x)Ga](y)InP layer 164 is a window layer.

Namely, the pn junction for photoelectric conversion in the GaInAs cell 160 is formed between the GaInAs layer 162 and the GaInAs layer 163 which have an In ratio of 1.5%, a distortion (strain) of 0.1%, and a band gap of 1.40 eV.

Further, the tunnel junction layer 150 includes the GaAs layer 151 and the GaAs layer 152.

In the deposition (growth) of the layered body 100A, the lower side where the GaAs substrate 20 exists is the light incident side, so that when the layered body 100A is to be bonded to the layered body 100B, the layered body 100A is turned over to be upside down. In this regard, the layered body 100A is grown downward in FIG. 1 which is opposite to the normal growing direction.

Specifically, the layers are sequentially grown from the cell having a wider band gap (i.e., GaInP cell 180) to the cell having narrower band gap (i.e., GaInAs cell 160). But finally, the p side becomes the lower side (the back side in the light incident direction).

The layered body 100B is formed by growing (depositing) the GaInPAs cell 120 and the bonding layer 130 on the InP substrate 110 by the MOCVD method. In the layered body 100B in FIG. 2A, the bonding layer 130 side, which is opposite to the InP substrate 110 side, is the light incident side.

The GaInPAs cell 120 includes the InP layer 121, the Ga(x)InP(y)As layer 122, the Ga(x)InP(y)As layer 123, and the [Al(x)Ga](y)InAs layer 124 from the InP substrate 110 side. The InP layer 121 is a BSF layer and the [Al(x)Ga](y)InAs layer 124 is a window layer.

By doing this, the layered body 100A and the layered body 100B are formed by epitaxial growth using the MOCVD method.

Next, as shown in FIG. 2B, the layered body 100A and the layered body 100B formed by epitaxial growth are directly bonded to each other.

A cleaning process and a surface activation process are performed on the surface of the bonding layer 140 of the layered body 100A and the surface of the bonding layer 130 of the layered body 100B, so that the bonding layer 130 is directly bonded to the bonding layer 140. As the surface activation process, a nitrogen (N₂) plasma process is performed in a vacuum at a temperature of 150 °C for the bonding.

By doing this, the layered body 100C of FIG. 2B is formed. The layered body 100C is formed by bonding the bonding layer 140 of the layered body 100A, which is turned over to be in the upside-down state, to the bonding layer 130 of the layered body 100B.

The layered body 100C has a structure where the GaInPAs cell 120, the bonding layer 130, the bonding layer 140, the tunnel junction layer 150, the GaInAs cell 160, the tunnel junction layer 170, the GaInP cell 180, the GaAs contact layer 40, the Ga(x)InP etching stop layer 30, and the GaAs substrate 20 are sequentially deposited on the InP substrate 110.

Next, the GaAs substrate 20 and the Ga(x)InP etching stop layer 30 are selectively etched from the layered body 100C of FIG. 2B to acquire the layered body 100D in FIG. 3A.

The etching of the GaAs substrate 20 and the Ga(x)InP etching stop layer 30 is performed as described below.

The etching of the GaAs substrate 20 may be performed by, for example, using a mixture of sulfuric acid (H₂SO₄), hydrogen peroxide (H₂O₂), and water (H₂O) as a wet etching solution. The mixture of sulfuric acid (H₂SO₄), hydrogen peroxide (H₂O₂), and water (H₂O) does not dissolve GaInP of the Ga(x)InP etching stop layer 30. Therefore, it becomes possible to stop the wet etching process by the Ga(x)InP etching stop layer 30.

Besides the above method, the etching of the GaAs substrate 20 may also be performed, for example, by a lift-off method where an AlAs sacrifice layer is used for selectively etching AlAs to separate the substrate and the cell (see Non-Patent Document 1) or by a smart-cut method which is frequently used in forming a Silicon On Insulator (SOI) substrates (see, for example, Applied Physics Letter 92, 103503(2008)). When any of above methods is used, the GaAs substrate 20 may be reused.

The Ga(x)InP etching stop layer 30 may be etched by using, for example, a mixture of hydrochloric acid (HCl) and water (H₂O).

By doing this, the GaAs substrate 20 and the Ga(x)InP etching stop layer 30 can be etched from the layered body 100C (see FIG. 2B) to form the layered body 100D (see FIG. 3A).

Next, the upper electrode 50 (see FIG. 1) is formed on the GaAs contact layer 40, and the lower electrode 10 is formed on the InP substrate 110.

The contact layer 40A is formed by removing a part other than a part disposed just under the upper electrode 50 from the contact layer 40 (see FIG. 3A).

The contact layer 40A may be formed by, for example, using a mixture of sulfuric acid (H₂SO₄), hydrogen peroxide (H₂O₂), and water (H₂O) as a wet etching solution. The mixture of sulfuric acid (H₂SO₄), hydrogen peroxide (H₂O₂), and water (H₂O) does not dissolve AlInP of the Al(x)InP layer 184. Therefore, it becomes possible to stop the wet etching process by the Al(x)InP layer 184 of the GaInP cell 180.

By doing this, the compound semiconductor photovoltaic cell 100 according to the first embodiment is formed. The compound semiconductor photovoltaic cell 100 in FIG. 3B is the same as the compound semiconductor photovoltaic cell 100 in FIG. 1.

The compound semiconductor photovoltaic cell 100 has a structure where sunlight is incident in the wider-band-gap cell side (i.e., the GaInP cell 180 side). It is preferable to dispose an antireflection film on the surface of the Al(x)InP layer 184 where sunlight is incident. The antireflection film is omitted in FIG. 3B.

In the compound semiconductor photovoltaic cell 100 according to the first embodiment, as the window layer of the GaInPAs cell 120 formed on the InP substrate 110, the [Al(x)Ga](y)InAs layer 124 having a band gap of 1.5 eV is formed, and as the bonding layer 130 formed on the GaInPAs cell 120, an InP bonding layer is formed.

Further, the band gap of the tunnel junction layer 150 and the bonding layer 140 is set to be greater than that of the GaInAs cell 160.

In order to ensure the light transmitted through the bonding layer 130 reaches the Ga(x)InP(y)As layer 122 and the Ga(x)InP(y)As layer 123 of the GaInPAs cell 120, the band gap of the [Al(x)Ga](y)InAs layer 124, which is the window layer of the GaInPAs cell 120, is set to 1.5 eV which is greater than that of the GaInAs cell 160.

Here, for example, if an InP layer is used as the window layer 124 similar to a compound semiconductor photovoltaic cell in the related technology, a part of the light transmitted through the GaInAs cell 160 (1.40 eV) is absorbed because the band gap of InP is 1.35 eV.

When a part of sunlight transmitted through the GaInAs cell 160 (1.40 eV) is absorbed as described above, an energy loss occurs which is a cause of reduction of efficiency of the compound semiconductor photovoltaic cell.

On the other hand, in the compound semiconductor photovoltaic cell 100 according to the first embodiment, in order to prevent the occurrence of the energy loss, the cell disposed at the most back (end) side from the light incident side is changed from a conventional GaAs cell to the GaInAs cell in the second photoelectric conversion cell (the cell grown on the GaAs substrate). As a result, it becomes possible to reduce the absorbed amount of sunlight before the sunlight is incident on the most front side of the first photoelectric conversion cell. Therefore, according to the first embodiment, it becomes possible to provide the compound semiconductor photovoltaic cell 100 where the efficiency is enhanced and a method of manufacturing the compound semiconductor photovoltaic cell 100.

Further, the [Al(x)Ga](y)InAs layer 124 having a greater band gap than the GaInAs cell 160 is used as the window layer. By doing this, the efficiency of the compound semiconductor photovoltaic cell 100 is improved.

Further, as a material allowing close lattice matching, for example, GaPSb, Al(Ga)InAs, Al(Ga)AsSb, Al(Ga)PSb, and AlInPSb have the compositions so that the band gap thereof is greater than or equal to that of the GaInAs cell 160 (1.40 eV) and can be grown on the InP substrate 110.

Therefore, a thin film formed of, for example, GaPSb, Al(Ga)InAs, Al(Ga)AsSb, Al(Ga)PSb, or Al(In)PSb may be used in place of the [Al(x)Ga](y)InAs layer 124 which is the window layer of the GaInPAs cell 120.

In this case, the composition is adjusted so that the band gap of the thin film formed of, for example, GaPSb, Al(Ga)InAs, Al(Ga)AsSb, Al(Ga)PSb, or Al(In)PSb used in place of the [Al(x)Ga](y)InAs layer 124 is greater than or equal to that of the GaInAs cell 160 (1.40 eV).

Here, the expression "(Ga)" is used because each of the compositions of Al(Ga)InAs, Al(Ga)AsSb, and Al(Ga)PSb may include Ga or may not include Ga. Namely, "Al(Ga)InAs" denotes AlGaInAs and AlInAs, "Al(Ga)AsSb" denotes AlGaAsSb and AlAsSb, and "Al(Ga)PSb" denotes AlGaPSb and AlPSb.

Here, the expression "(In)" is used because the composition Al(In)PSb may include In or may not include In. Namely, "Al(In)PSb" denotes AlInPSb and AlPSb.

Further, "(Al)GaInP(As)" denotes AlGaInP, GaInPAs, and GaInP.

In a triple-junction photovoltaic cell such as the compound semiconductor photovoltaic cell 100 according to the first embodiment, OYO BUTURI Vol.79, No. 5, 2010 page 436 describes that as the combination of the band gaps of the three cells, values "1.9 eV/1.42 eV/1.0 eV" and "1.7 eV/1.2 eV/0.67 eV" are preferable to the values "1.88 eV/1.4 eV/0.67 eV" of a triple-junction photovoltaic cell in the related technology.

However, it is difficult to have such combination band gaps as described above with a single lattice constant.

In this regard, according to the first embodiment, the compound semiconductor photovoltaic cell 100 is formed by bonding two cells having different lattice constants (i.e., the layered body 100A and the layered body 100B, see FIG. 2A) using a direct bonding method. By doing this, it becomes easier to form the compound semiconductor photovoltaic cell 100 including cells having different lattice constants.

In the above description, a case is described where cells are formed on the InP substrate 110 and the GaAs substrate 20 by MOCVD method. However, the cell may be formed by Molecular Beam Epitaxy (MBE) method.

Also, in the above description, a case is described where the compound semiconductor photovoltaic cell 100 is formed by using the layered body 100A and the layered body 100B using the InP substrate 110 and the GaAs substrate 20, respectively. However, any combination other than the combination of the InP substrate 110 and the GaAs substrate 20 may be used.

For example, any of the combinations including, for example, Ge substrate and InP substrate, GeSb substrate and GaAs substrate, GaSb substrate and Ge substrate, Si substrate and Ge substrate, and Si substrate and GaAs substrate may be used to form the layered body 100B and the layered body 100A.

Further, in the above description, a case is described where the layered bodies 100A and 100B are directly bonded. However, the layered bodies 100A and 100B may be mechanically bonded as shown in FIG. 4.

Further, in the above description, a case is described where the GaInPAs cell 120 is used as the InP lattice matching based material cell. However, the InP lattice matching based material cell is not limited to the GaInPAs cell 120. For example, a cell expressed in GaIn(P)As may be used.

Here, the expression "(P)" is used because the composition GaIn(P)As may include P or may not include P. Namely, "GaIn(P)As" denotes GaInPAs and GaInAs. Therefore, a GaInAs cell may be used in place of the GaInPAs cell 120.

Further, in the above description, a case is described where the GaInP cell 180 is used as the GaAs lattice matching based material cell. However, the GaAs lattice matching based material cell is not limited to the GaInP cell 180. A cell expressed in (Al)GaInP(As) may be used.

Here, the expressions "(Al)" and "(As)" are used because the composition (Al)GaInP(As) may include Al or may not include Al and may include Al and may not include As. Namely, "(Al)GaInP(As)" denotes AlGaInP, GaInPAs, and GaInP. Therefore, an AlGaInP cell or a GaInPAs cell may be used in place of the GaInP cell 180.

FIG. 4 is a cross-sectional view of a compound semiconductor photovoltaic cell 101 according to a first modified example of the first embodiment.

In the compound semiconductor photovoltaic cell 101 according to the first modified example of the first embodiment, the bonding layer 130 and the bonding layer 140 of FIG. 1 are mechanically bonded to each other.

In the compound semiconductor photovoltaic cell 101 of FIG. 4, the bonding layer 130 and the bonding layer 140 are bonded via a fixing member 102. As the fixing member 102, a Pd Nanoparticle Array may be used.

The Pd Nanoparticle Array is for causing conductive nanoparticles to be self-arranged on the junction interface, with the use of the separation arrangement of a block copolymer. Nano arrangements of Pd, Au, Pt, Ag, etc., are possible. A diluted solution of a block copolymer is spin-coated, the block copolymer is caused to be self-arranged, and the block copolymer is exposed to an aqueous solution including metal ions such as Pd²+ (palladium ions), so that metal ions are selectively formed in the block copolymer. Then, Ar (argon) plasma is radiated, so that the block copolymer template is removed, and a nanoparticle array which is self-arranged, is formed. Light is transmitted through parts without nanoparticles. By using a palladium nanoparticle array, light that has been transmitted through the GaInPAs cell 160 can be efficiently guided to the GaInPAs cell 120.

With the Pd Nanoparticle Array formed on either the bonding layer 130 or the bonding layer 140, the bonding layer 130 and the bonding layer 140 are bonded to each other to form the compound semiconductor photovoltaic cell 101.

The fixing member 102 is an example of a fixing unit. The method of mechanically bonding two layered bodies with the fixing member 102 is called "mechanical stack".

The fixing member 102 is not limited to the Pd Nanoparticle Array. For example, the fixing member 102 may be a Nanoparticle Array including another metal (e.g., Au) or may be another mechanical means.

The compound semiconductor photovoltaic cell 101 includes surface layers 130A and 140A in place of the bonding layers 130 and 140. The surface layers 130A and 140A are similar to the bonding layers 130 and 140 but are not directly bonded to each other. Therefore, those layers are called "surface layers 130A and 140A" in FIG. 4.

As described above, in the compound semiconductor photovoltaic cell 101, the bonding layers 130 and 140 are bonded with the fixing member 102. Therefore, it is not necessary to include the tunnel junction layer 150 (see FIG. 1) between the GaInAs cell 160 and the bonding layer 140, so that the GaInAs cell 160 is directly bonded to the bonding layer 140.

As described above, the layered body including the GaInPAs cell 120 may be bonded to the layered body including the GaInAs cell 160 and the GaInP cell 180 by mechanical stack.

Further, the compound semiconductor photovoltaic cell 100 according to the first embodiment may also be modified as shown in FIG. 5.

FIG. 5 is a cross-sectional view of a compound semiconductor photovoltaic cell 103 according to a second modified example of the first embodiment.

The compound semiconductor photovoltaic cell 103 according to the second modified example of the first embodiment includes the electrode 10, the InP substrate 110, the GaInPAs cell 120, the bonding layer 130, the tunnel junction layer 150A, the GaInAs cell 160, the tunnel junction layer 170, the GaInP cell 180, the contact layer 40A, and the electrode 50.

In the compound semiconductor photovoltaic cell 103, the bonding layer 140 and the n+type GaAs layer 151 are removed from the compound semiconductor photovoltaic cell 100, so that the bonding layer 130 is directly bonded to the p+type GaAs layer 152. The tunnel junction layer 150A in FIG. 5 is similar to the p+type GaAs layer 152 in FIG. 1. In such a compound semiconductor photovoltaic cell 103, a tunnel junction is formed between the bonding layer 130 and the tunnel junction layer 150A.

In a case of a multi-junction photovoltaic cell having multiple cells, in order to equalize the values of the currents that can be drawn from the multiple cells, any of the multiple cells may be thinly formed so that light having a absorbable wavelength can be transmitted therethrough and the cell in the back side in the light incident direction can absorb the light.

Further, in a case where the GaInAs cell 160 is thin, the transmission light, without being absorbed by the GaInAs cell 160, is absorbed by the tunnel junction layer 150 and the bonding layers 140 and 130, which affects the efficiency. In such a case, it is desired that the overall thickness of the tunnel junction layer 150 and the bonding layers 140 and 130 be reduced as much as possible.

Therefore, by removing the bonding layer 140 and the n+type GaAs layer 151 of FIG. 1 so that the tunnel junction is formed by the bonding layer 130 and the tunnel junction layer 150A as shown in FIG. 5, it becomes possible to provide the compound semiconductor photovoltaic cell 103 having a thickness less than that of the compound semiconductor photovoltaic cell 100 of FIG. 1.

### Second embodiment

In the first embodiment, a triple-junction type compound semiconductor photovoltaic cell 100 including the GaInP cell 180, the GaInAs cell 160, and the GaInPAs cell 120 is formed. The combination of the band gaps of the three photoelectric conversion cells thereof is 1.9 eV/1.40 eV/1.0 eV

### Second embodiment, not being part of the present invention:

In a second embodiment, not being part of the present invention, by adding a GaInAs cell (0.75 eV) to the GaInP cell 180, the GaInAs cell 160, and the GaInPAs cell 120, a quad-junction type compound semiconductor photovoltaic cell 200 is provided. The combination of the band gaps of the four photoelectric conversion cells thereof is 1.9 eV/1.40 eV/1.0 eV/0.75 eV.

FIG. 6 is a cross-sectional view of the compound semiconductor photovoltaic cell 200 according to the second embodiment. In the following, the same reference numerals are repeatedly used to describe the same constituent elements as those in the compound semiconductor photovoltaic cell 100 in the first embodiment, and the repeated descriptions thereof may be omitted.

The compound semiconductor photovoltaic cell 200 includes the electrode 10, the InP substrate 110, a GaInAs cell 210, a tunnel junction layer 220, the GaInPAs cell 120, the bonding layer 130, the bonding layer 140, the tunnel junction layer 150, the GaInAs cell 160, the tunnel junction layer 170, the GaInP cell 180, the contact layer 40A, and the electrode 50.

The compound semiconductor photovoltaic cell 200 according to the second embodiment is a quad-junction photovoltaic cell in which the GaInAs cell 210 (0.75 eV), the GaInPAs cell 120 (1.0 eV), the GaInAs cell 160 (1.40 eV), the GaInP cell 180 (1.9 eV) are connected in series.

Here, the GaInAs cell 210 and the GaInPAs cell 120 are examples of multiple first photoelectric conversion cells which are formed of a first compound semiconductor material.

In FIG. 6, light is incident in the direction from the upper side to the lower side in the figure (i.e., in the direction from the GaInP cell 180 to the GaInAs cell 210).

IEEE Document (Processing of the 28th IEEE Photovoltaic Specialists Conference (2009) pp.1090-1 093) describes that it is preferable for a quad-junction photovoltaic cell to have a band gap balance of a combination approximately 1.9 eV/1.4 eV/1.0 eV/0.7 eV.

In the compound semiconductor photovoltaic cell 200, the GaInAs cell 210 and a tunnel junction layer 220 are formed between the InP substrate 110 and the GaInPAs cell 120 of the compound semiconductor photovoltaic cell 100 according to the first embodiment.

The GaInAs cell 210 includes a p-type InP layer 211, a p-type Ga(x)InAs layer 212, an n-type Ga(x)InAs layer 213, and an n-type InP layer 214. The InP layer 211 is a BSF layer, and the InP layer 214 is a window layer.

Here, the GaInAs cell 210 may be regarded as a cell which does not include the InP layer 211 and the InP layer 214 so as to include only the Ga(x)InAs layer 212 and the Ga(x)InAs layer 213. In this case, it is assumed that the InP layer 214 is formed on the light incident side of the GaInAs cell 210 including the Ga(x)InAs layer 212 and the Ga(x)InAs layer 213 and the InP layer 211 is formed on the back side of the GaInAs cell 210 in the light incident direction.

The band gap of the p-type Ga(x)InAs layer 212 and the n-type Ga(x)InAs layer 213 is 0.75 eV.

The tunnel junction layer 220 is formed between the GaInPAs cell 120 and the GaInAs cell 210. The tunnel junction layer 220 includes an n+type InP layer 221 and a p+type Al(x)InAs layer 222.

As the impurity to set the conductive type of the InP layer 221 to n+type, for example, silicon (Si) may be used. As the impurity to set the conductive type of the Al(x)InAs layer 222 to p+type, for example, carbon (C) may be used. The n+type InP layer 221 and the p+type Al(x)InAs layer 222 include a thin pn junction doped in high concentration.

The n+type InP layer 221 and the p+type Al(x)InAs layer 222 of the tunnel junction layer 220 are doped with higher concentration than the GaInPAs cell 120. The tunnel junction layer 220 is a junction layer which is formed in order to flow current between the p-type Ga(x)InP(y)As layer 122 of the GaInPAs cell 120 and the n-type Ga(x)InAs layer 213 of the GaInAs cell 210 (by tunnel junction).

The compound semiconductor photovoltaic cell 200 according to the second embodiment has a combination of band gaps 1.9 eV/1.40 eV/ 1.0 eV/0.75 eV by the four photoelectric conversion cells which are the GaInP cell 180, the GaInAs cell 160, the GaInPAs cell 120, and the GaInAs cell 210.

Therefore, according to the second embodiment, it becomes possible to provide the compound semiconductor photovoltaic cell 200 having higher energy conversion efficiency than the compound semiconductor photovoltaic cell 100 according to the first embodiment.

Further, similar to the case of the second modified example of the first embodiment, the thickness of the compound semiconductor photovoltaic cell 200 of FIG. 6 may be reduced by removing the bonding layer 140 and the n+type GaAs layer 151 to form the tunnel junction by the bonding layer 130 and the p+type GaAs layer 152.

### Third embodiment:

FIG. 7 is a cross-sectional drawing of a compound semiconductor photovoltaic cell 300 according to a third embodiment.

The compound semiconductor photovoltaic cell 300 according to the third embodiment is formed with a composition in which, as a substrate for forming the second photoelectric conversion cell, a Ge substrate is used in place of the GaAs substrate used in the compound semiconductor photovoltaic cell 100 (see FIG. 1). The lattice constant of Ge is greater than that of GaAs by approximately 0.08%, so that the GaInAs cell 160 (1.40 eV) having an In composition of 1.5% as described in the first embodiment can be lattice-matched. Therefore, by adjusting the compositions of the other layers such as the GaInP cell 180, it becomes possible to form all the layers with a lattice matching condition. The band gap of the GaInP cell 180 is reduced to 1.88 eV. From the viewpoint of the lattice matching, the composition of the tunnel junction layer 150 and the bonding layer 140 is GaInAs having an In composition similar to the GaInAs cell.

Further, in the compound semiconductor photovoltaic cell 300 according to the third embodiment, the bonding layer 130 and the [Al(x)Ga](y)InAs layer 124 in the compound semiconductor photovoltaic cell 100 according to the first embodiment (FIG. 1) are replaced by the bonding layer 330 and a Ga(x)InP layer 324, respectively.

The compound semiconductor photovoltaic cell 300 according to the third embodiment includes the electrode 10, the InP substrate 110, a GaInPAs cell 320, the bonding layer 330, the bonding layer 140, the tunnel junction layer 150, the GaInAs cell 160, the tunnel junction layer 170, the GaInP cell 180, the contact layer 40A, and the electrode 50.

The GaInPAs cell 320 includes the InP layer 121, the Ga(x)InP(y)As layer 122, the Ga(x)InP(y)As layer 123, and a Ga(x)InP layer 324. Namely, in the GaInPAs cell 320, the [Al(x)Ga](y)InAs layer 124 of the GaInPAs cell 120 in the first embodiment is replaced by the Ga(x)InP layer 324. The band gap of the Ga(x)InP layer 324 is 1.40 eV. The window layer 324 is a GaInP layer having a Ga composition of 7%, having a tensile strain of 0.5%, and having a band gap of 1.40 eV.

Further, as the window layer 324, for example, a GaPSb layer, Al(Ga)InAs, Al(Ga)AsSb, Al(GA)Psb, or AlInPSb may be used. Those materials also have a composition where the band gap is greater than or equal to the band gap of the GaInAs cell 160 (1.40 eV) and can be grown on the InP substrate 110.

Therefore, in place of the Ga(x)InP layer 324 which is the window layer of the GaInPAs cell 320, a thin film layer formed of, for example, GaPSb, Al(Ga)InAs, Al(Ga)AsSb, Al(GA)Psb, or AlInPSb may be used.

As the bonding layer 330, a GaInP layer having a Ga composition of 7% and having a tensile strain of 0.5% is used. The band gap of the GaInP layer is 1.40 eV. Namely, the bonding layer 330 is a layer formed by adding Ga to the bonding layer 130 (InP with a Ga composition of 0%) in the first embodiment.

The GaInAs cell 160 includes the p-type Ga(x)InP layer 161, a p-type Ga(x)InAs layer 162, a n-type Ga(x)InAs layer 163, and the n-type [Al(x)Ga](y)InP layer 164.

The GaInAs cell 160 has a distortion (strain) of approximately 0.1% relative to the GaAs substrate 20 but is in lattice matching with a Ge substrate.

In the compound semiconductor photovoltaic cell 300 according to the third embodiment, the Ga(x)InP layer 324 having a band gap of 1.4 eV is formed as the window layer of the GaInPAs cell 320 formed on the InP substrate 110, and the GaInP bonding layer having a band gap of 1.40 eV is formed as the bonding layer 330 formed thereon.

The GaInP bonding layer formed as the bonding layer 330 has a Ga composition of 7% and has a tensile strain of 0.5%. The band gap of the GaInP bonding layer is 1.40 eV. The band gap (1.40 eV) of the bonding layer 330 is set to be greater than or equal to the band gap of the (1.40 eV) of the GaInAs cell 160 which is a photoelectric conversion cell adjacent to the bonding layer 330 on the light incident side.

Namely, the Ga(x)InP layer used as the bonding layer 330 has the above-described band gap so that the light transmitted through the GaInAs cell 160, which is the adjacent photoelectric conversion cell disposed on the light incident side (the upstream side) in the light incident direction, without being absorbed therein is guided to the GaInPAs cell 320 disposed on the back side thereof in the light incident direction.

Further, the band gap of the tunnel junction layer 150 and the bonding layer 140 is 1.40 eV which is equal to the band gap (1.40 eV) of the GaInAs cell 160.

In the compound semiconductor photovoltaic cell 300 according to the third embodiment, the band gap of the Ga(x)InP layer 324, which is the window layer of the GaInPAs cell 320, is set to 1.40 eV which is equal to that of the GaInAs cell 160, and in addition, the band gap of the bonding layer 330 is set as described above.

In a related technology, an InP layer (1.35 eV) is used as the bonding layer to bond wafers.

Here, for example, similar to a compound semiconductor photovoltaic cell in a related technology, when an InP layer is used as the bonding layer 330, since the band gap of InP is 1.35 eV, a part of sunlight transmitted through the GaInAs cell 160 (1.40 eV) is absorbed.

When a part of sunlight transmitted through the GaInAs cell 160 (1.40 eV) is absorbed by the InP layer, an energy loss occurs which is a cause of reduction of efficiency of the compound semiconductor photovoltaic cell.

On the other hand, in the compound semiconductor photovoltaic cell 300 according to the third embodiment, in order to prevent the occurrence of the energy loss, the Ga(x)InP layer having a band gap equal to that of the GaInAs cell 160 is used as the bonding layer 330.

By doing this, according to the third embodiment, it becomes possible to provide the compound semiconductor photovoltaic cell 300 having higher efficiency and a method of manufacturing the compound semiconductor photovoltaic cell 300.

Further, similar to the case of the second modified example of the first embodiment, the thickness of the compound semiconductor photovoltaic cell 300 of FIG. 7 may be reduced by removing the bonding layer 140 and the n+type GaAs layer 151 to form the tunnel junction by the bonding layer 130 and the p+type GaAs layer 152.

### Fourth embodiment:

FIG. 8 is a cross-sectional view of a compound semiconductor photovoltaic cell 400 according to a fourth embodiment of the present invention.

The compound semiconductor photovoltaic cell 400 according to the fourth embodiment is a quad-junction photovoltaic cell which is formed by forming the GaInAs cell 210 and the tunnel junction layer 220 between the InP substrate 110 and the GaInPAs cell 320 of the compound semiconductor photovoltaic cell 300 according to the third embodiment.

This relationship is similar to the relationship in which the quad-junction-type compound semiconductor photovoltaic cell 200 according to the second embodiment is formed by forming the GaInAs cell 210 and the tunnel junction layer 220 between the InP substrate 110 and the GaInPAs cell 120 of the compound semiconductor photovoltaic cell 100 according to the first embodiment.

In the following, the same reference numerals are repeatedly used to describe the same constituent elements as those in the first through third embodiments, and the repeated descriptions thereof may be omitted.

The compound semiconductor photovoltaic cell 400 according to the fourth embodiment includes the electrode 10, the InP substrate 110, the GaInAs cell 210, the tunnel junction layer 220, the GaInPAs cell 320, the bonding layer 330, the bonding layer 140, the tunnel junction layer 150, the GaInAs cell 160, the tunnel junction layer 170, the GaInP cell 180, the contact layer 40A, and the electrode 50.

The combination of the band gaps of the GaInP cell 180, the GaInAs cell 160, the GaInPAs cell 320, and the GaInAs cell 210 which are four photoelectric conversion cells thereof is 1.88 eV/1.40 eV/1.0 eV/0.75 eV.

The compound semiconductor photovoltaic cell 400 according to the fourth embodiment is a quad-junction photovoltaic cell in which the GaInAs cell 210 (0.75 eV), the GaInPAs cell 320 (1.0 eV), the GaInAs cell 160 (1.40 eV), the GaInP cell 180 (1.88 eV) are connected in series.

In FIG. 8, light is incident in the direction from the upper side to the lower side in the figure (i.e., in the direction from the GaInP cell 180 to the GaInAs cell 210).

The compound semiconductor photovoltaic cell 400 according to the fourth embodiment has a combination of band gaps 1.88 eV/1.40 eV/ 1.0 eV/0.75 eV by the four photoelectric conversion cells which are the GaInP cell 180, the GaInAs cell 160, the GaInPAs cell 320, and the GaInAs cell 210.

Therefore, according to the fourth embodiment, it becomes possible to provide the compound semiconductor photovoltaic cell 400 having higher energy conversion efficiency than the compound semiconductor photovoltaic cell 300 according to the third embodiment.

Further, similar to the case of the second modified example of the first embodiment, the thickness of the compound semiconductor photovoltaic cell 400 of FIG. 8 may be reduced by removing the bonding layer 140 and the n+type GaAs layer 151 to form the tunnel junction by the bonding layer 130 and the p+type GaAs layer 152.

### Fifth embodiment:

FIG. 9 is a cross-sectional view of a compound semiconductor photovoltaic cell 1100 according to a fifth embodiment;
The compound semiconductor photovoltaic cell 1100 includes an electrode 1010, an InP substrate 1110, a GaInPAs cell 1120, a bonding layer 1130, a bonding layer 1140, a tunnel junction layer 1150, a GaAs cell 1160, a tunnel junction layer 1170, a GaInP cell 1180, a contact layer 1040A, and an electrode 1050.

The compound semiconductor photovoltaic cell 1100 according to the fifth embodiment is a triple-junction photovoltaic cell in which the GaInPAs cell 1120 (1.0 eV), the GaAs cell 1160 (1.40 eV), and the GaInP cell 1180 (1.9 eV) are connected in series.

As the cells included in the compound semiconductor photovoltaic cell 1100, there are an Indium Phosphorus (InP) based photoelectric conversion cell and a Gallium Arsenic (GaAs) based photoelectric conversion cell. The InP based photoelectric conversion cell refers to a photoelectric conversion cell which is formed of a material system that is substantially in lattice matching with InP and can be crystal grown on the InP substrate 1110. Here, the material that is substantially in lattice matching with InP and can be crystal grown on the InP substrate 1110 is called an "InP lattice matching based material". Further, the cell formed of the "InP lattice matching based material" is called an "InP lattice matching based material cell".

On the other hand, the GaAs based photoelectric conversion cell refers to a photoelectric conversion cell which is formed of a material system that is substantially in lattice matching with GaAs or Germanium (Ge) which has a lattice constant substantially equal to that of GaAs and can be crystal grown on a GaAs substrate or a Ge substrate. Here, the material that is substantially in lattice matching with GaAs or Ge which has a lattice constant substantially equal to that of GaAs and can be crystal grown on a GaAs substrate or a Ge substrate is called a "GaAs lattice matching based material". Further, the cell formed of the "GaAs lattice matching based material" is called a "GaAs lattice matching based material cell".

Those terms are similarly used in sixth through eighth embodiments as well.

In the compound semiconductor photovoltaic cell 1100, the GaInPAs cell 1120 is the InP based photoelectric conversion cell and the GaAs cell 1160 and the GaInP cell 1180 are the GaAs based photoelectric conversion cell.

Here, the InP substrate 1110 is an example of a compound semiconductor substrate or a first compound semiconductor substrate. The GaInPAs cell 1120 is an example of a first photoelectric conversion cell which is made of a first compound semiconductor material.

The bonding layer 1130 is an example of a bonding layer that is made of a second compound semiconductor material and is deposited on the GaInPAs cell 1120. The GaAs cell 1160 and the GaInP cell 1180 are examples of a plurality of second photoelectric conversion cells which are made of a third compound semiconductor material.

In FIG. 9, light is incident in the direction from the upper side to the lower side in the figure (i.e., in the direction from the GaInP cell 1180 to the GaInPAs cell 1120) (hereinafter the "light incident direction").

The electrode 1010 is an electrode serving as a lower electrode disposed on the back (deeper) side in the light incident direction. As the electrode 1010, an electrode, which is formed by stacking metal layers made of, for example Ti/Pt/Au, may be used.

As the InP substrate 1110, a wafer, which is made of, for example, p-type single-crystal indium phosphorus, may be used. As an impurity, for example, Zn may be used.

The GaInPAs cell 1120 is formed on a surface of the InP substrate 1110. The GaInPAs cell 1120 includes a p-type InP layer 1121, a p-type Ga(x)InP(y)As layer 1122, a n-type Ga(x)InP(y)As layer 1123, and a n-type [Al(x)Ga](y)InAs layer 1124.

The GaInPAs cell 1120 includes crystal layers of GaInPAs which is in lattice matching with InP. The InP layer 1121, the Ga(x)InP(y)As layer 1122, the Ga(x)InP(y)As layer 1123, and the [Al(x)Ga](y)InAs layer 1124 are deposited in the order on the surface of the InP substrate 1110.

The InP layer 1121 is a Back Surface Field (BSF) layer disposed on the back side in the light incident direction. The pn junction of the GaInPAs cell 1120 is formed between the Ga(x)InP(y)As layer 1122 and the Ga(x)InP(y)As layer 1123. The [Al(x)Ga](y)InAs layer 1124 is a window layer disposed on the front side (light incident side) in the light incident direction.

Here, the GaInPAs cell 1120 may be regarded as a cell having the Ga(x)InP(y)As layer 1122 and the Ga(x)InP(y)As layer 1123, which form the pn junction, the [Al(x)Ga](y)InAs layer 1124 formed on the light incident side of the GaInPAs cell 1120, and the InP layer 1121 formed on the back side in the light incident direction.

The InP layer 1121 is used as the BSF layer, and therefore the InP layer 1121 has a band gap greater than the band gap (1.0 eV) of the p-type Ga(x)InP(y)As layer 1122 and the n-type Ga(x)InP(y)As layer 1123. As impurity of the InP layer 1121, Zinc (Zn) may be used.

The conductive type of the Ga(x)InP(y)As layer 1122 becomes p-type by using, for example, Zn as impurity.

The conductive type of the Ga(x)InP(y)As layer 1123 becomes n-type by using, for example, Si as impurity.

In the Ga(x)InP(y)As layer 1122 and the Ga(x)InP(y)As layer 1123, the rate "x" of Ga and the rate "y" of P are adjusted so that the band gap the layers is 1.0 eV.

The [Al(x)Ga](y)InAs layer 1124 is used as a window layer. Therefore, the [Al(x)Ga](y)InAs layer 1124 has a band gap greater than the band gap (1.0 eV) of the Ga(x)InP(y)As layer 1122 and the Ga(x)InP(y)As layer 1123.

In the fifth embodiment, the band gap of the [Al(x)Ga](y)InAs layer 1124 is set to, for example, 1.5 eV. The impurity of the [Al(x)Ga](y)InAs layer 1124, for example, Si may be used.

AlGaInAs is in lattice matching with InP and therefore is suitable for depositing the Ga(x)InP(y)As layer 1123.

The bonding layer 1130 is bonded to the bonding layer 1140 by a cleaning process and a surface activation process in a step of manufacturing the compound semiconductor photovoltaic cell 1100. The compound semiconductor photovoltaic cell 1100 is manufactured by bonding two layered bodies.

The bonding layer 1130 is formed on the uppermost surface of one of the two layered bodies, and the bonding layer 1140 is formed on the uppermost surface of the other layered body. Then, the bonding layer 1130 and the bonding layer 1140 are bonded to each other to form the compound semiconductor photovoltaic cell 1100.

As the bonding layer 1130, an n+type Ga(x)InP layer is used. The impurity concentration of the bonding layer 1130 is set to be greater than that of the [Al(x)Ga](y)InAs layer 1124. By doing, the conductive type of the bonding layer 1130 is an n+type.

The Ga(x)InP layer used as the bonding layer 1130 may be, for example, a GaInP layer having a Ga composition of 10% (x=0.1), a tensile strain of 0.7%, and a band gap of 1.42 eV.

Herein, a case is described where the band gap of the Ga(x)InP layer used as the bonding layer 1130 is 1.42 eV. However, the band gap may be made greater than 1.42 eV by increasing the Ga composition rate.

The band gap of the Ga(x)InP layer used as the bonding layer 1130 is greater than or equal to the band gap (1.42 eV) of the GaAs cell 1160 disposed on the light incident (upstream) side of the bonding layer 1130 in the light incident direction.

Namely, the band gap of the bonding layer 1130 is greater than or equal to the band gap (1.42 eV) of the GaAs cell 1160 disposed on the light incident (upstream) side of the bonding layer 1130 in the light incident direction.

Further, between the bonding layer 1130 and the GaAs cell 1160, the bonding layer 1140 and the tunnel junction layer 1150 are formed. Both the bonding layer 1140 and the tunnel junction layer 1150 include GaAs so as to have a band gap of 1.42 eV.

Therefore, the band gap of the bonding layer 1130 is greater than or equal to both the band gap of the photoelectric conversion cell (GaAs cell 1160 in this case) disposed on the light incident (upstream) side of the bonding layer 1130 in the light incident direction and the band gap of the layers between the bonding layer 1130 and the photoelectric conversion cell disposed on the light incident (upstream) side of the bonding layer 1130 (i.e., the bonding layer 1140 and the tunnel junction layer 1150), so that the band gap of the bonding layer 1130 is greater than or equal to 1.42 eV in this case.

In the compound semiconductor photovoltaic cell 1100 according to the fifth embodiment, why the band gap of the bonding layer 1130 is set as described above is to prevent the light, which is transmitted without being absorbed by the GaAs cell 1160, the tunnel junction layer 1150, and the bonding layer 1140, from being absorbed by the bonding layer 1130.

Namely, by doing this, it becomes possible to effectively guide sunlight to the GaInPAs cell 1120 disposed on the back side (downstream) side of the bonding layer 1130 in the light incident direction without the sunlight being absorbed by the bonding layer 1130.

Further, to ensure the light transmitted through the bonding layer 1130 is to reach the Ga(x)InP(y)As layer 1122 and the Ga(x)InP(y)As layer 1123 of the GaInPAs cell 1120, the band gap of the[Al(x)Ga](y)InAs layer 1124, which is the window layer of the GaInPAs cell 1120, is set to, for example, 1.5 eV.

In this case, similar to a compound semiconductor photovoltaic cell in the related technology, if, for example, an InP layer is used as the bonding layer 1130, a part of the light transmitted through the GaAs cell 1160 (1.42 eV) is absorbed by the InP layer because the band gap of the InP layer is 1.35 eV.

In the compound semiconductor photovoltaic cell 1100 according to the fifth embodiment, in order to prevent the occurrence of energy loss, the Ga(x)InP layer having the band gap greater than or equal to that of the GaAs cell 1160, the tunnel junction layer 1150, and the bonding layer 1140 is used as the bonding layer 1130.

The bonding layer 1140 is bonded to the bonding layer 1130, which is disposed on the InP substrate 1110 side thereof, by a cleaning process and a surface activation process in a step of manufacturing the compound semiconductor photovoltaic cell 1100. As the bonding layer 1140, for example, an n+type GaAs layer may be used. The band gap of the GaAs layer is 1.42 eV, which is the same as that of the bonding layer 1130. The impurity concentration of the bonding layer 1140 is set to be similar to that of the bonding layer 1130.

In the compound semiconductor photovoltaic cell 1100 of FIG. 9, the upper side of the boundary between the bonding layer 1130 and the bonding layer 1140 is formed by sequentially depositing layers in, for example, an upside-down state. Therefore, the bonding layer 1140 is deposited on the tunnel junction layer 1150.

The tunnel junction layer 1150 is formed between the bonding layer 1140 and the GaAs cell 1160. In the compound semiconductor photovoltaic cell 1100 of FIG. 9, the upper side of the boundary between the bonding layer 1130 and the bonding layer 1140 is formed by sequentially depositing layers in, for example, the upside-down state. Therefore, the tunnel junction layer 1150 is deposited on the GaAs cell 1160.

The tunnel junction layer 1150 includes an n+type GaAs layer 1151 and a p+type GaAs layer 1152. As the impurity to set the conductive type to n-type, for example, tellurium (Te) may be used. As the impurity to set the conductive type to p-type, for example, carbon (C) may be used. The n+type GaAs layer 1151 and the p+type GaAs layer 1152 include a thin pn junction doped in high concentration.

The GaAs layer 1151 and the GaAs layer 1152 of the tunnel junction layer 1150 are doped with higher concentration than the GaAs cell 1160. The tunnel junction layer 1150 is a junction layer which is formed in order to flow current between a p-type GaAs layer 1162 of the GaAs cell 1160 and the n-type Ga(x)InP(y)As layer 1123 of the GaInPAs cell 1120 (by tunnel junction).

The GaAs cell 1160 is formed between the tunnel junction layer 1150 and the tunnel junction layer 1170.

The GaAs cell 1160 includes a p-type Ga(x)InP layer 1161, the p-type GaAs layer 1162, an n-type GaAs layer 1163, and an n-type [Al(x)Ga](y)InP layer 1164.

The Ga(x)InP layer 1161, the GaAs layer 1162, the GaAs layer 1163, and the [Al(x)Ga](y)InP layer 1164 are deposited in this order on the surface of the tunnel junction layer 1150. In an actual manufacturing process, the GaAs cell 1160 is deposited on the tunnel junction layer 1170 in, for example, the upside-down state.

Therefore, in an actual manufacturing process, for example, the [Al(x)Ga](y)InP layer 1164, the GaAs layer 1163, the GaAs layer 1162, and the Ga(x)InP layer 1161 are deposited in this order on the tunnel junction layer 1170.

The Ga(x)InP layer 1161 is a Back Surface Field (BSF) layer disposed on the back side in the light incident direction. The pn junction of the GaAs cell 1160 is included in the GaAs layer 1162 and the GaAs layer 1163. The [Al(x)Ga](y)InP layer 1164 is a window layer disposed on the front side (light incident side) in the light incident direction.

Here, the GaAs cell 1160 may be regarded as a cell having the GaAs layer 1162 and the GaAs layer 1163, which form the pn junction, the [Al(x)Ga](y)InP layer 1164 formed on the light incident side of the GaInPAs cell 1120, and the Ga(x)InP layer 1161 formed on the back side in the light incident direction.

The Ga(x)InP layer 1161 is used as the BSF layer, and therefore the Ga(x)InP layer 1161 has a band gap greater than the band gap (1.42 eV) of the p-type GaAs layer 1162 and the n-type GaAs layer 1163. As impurity of the Ga(x)InP layer 1161, for example, Zn may be used.

The conductive type of the GaAs layer 162 becomes p-type by using, for example, Zn as an impurity.

The conductive type of the GaAs layer 1163 becomes n-type by using, for example, Si as an impurity.

The band gap of the GaAs layer 1162 and the GaAs layer 1163 is 1.42 eV.

The [Al(x)Ga](y)InP layer 1164 is used as a window layer. Therefore, the [Al(x)Ga](y)InP layer 1164 has a band gap greater than the band gap (1.42 eV) of the p-type GaAs layer 1162 and the n-type GaAs layer 1163.

In the fifth embodiment, the [Al(x)Ga](y)InP layer 1164 has a band gap greater than the band gap (1.42 eV) of the p-type GaAs layer 1162 and the n-type GaAs layer 1163. As an impurity of the [Al(x)Ga](y)InP layer 1164, for example, Si may be used.

The tunnel junction layer 1170 is formed between the GaAs cell 1160 and the GaInP cell 1180. The upper side of the boundary between the bonding layer 1130 and the bonding layer 1140 in the compound semiconductor photovoltaic cell 1100 of FIG. 9 is formed by sequentially depositing layers in, for example, an upside-down state. Therefore, the tunnel junction layer 1170 is deposited on the GaInP cell 1180.

The tunnel junction layer 1170 includes an n-type Ga(x)InP layer 1171 and a p-type Al(x)GaAs layer 1172. As an impurity to set the conductive type to n-type, for example, tellurium (Te) may be used. As the impurity to set the conductive type to p-type, for example, carbon (C) may be used. The n-type Ga(x)InP layer 1171 and the p-type Al(x)GaAs layer 1172 include a thin pn junction doped in high concentration.

The n-type Ga(x)InP layer 1171 and the p-type Al(x)GaAs layer 1172 of the tunnel junction layer 1170 are doped with higher concentration than the GaInP cell 1180. The tunnel junction layer 1170 is a junction layer which is formed in order to flow current between a p-type Ga(x)InP layer 1182 of the GaInP cell 180 and the n-type GaAs layer 1163 of the GaAs cell 1160 (by tunnel junction).

The GaInP cell 1180 is formed between the tunnel junction layer 1170 and the contact layer 1040A.

The GaInP cell 180 includes a p-type Al(x)InP layer 1181, a p-type Ga(x)InP layer 1182, an n-type Ga(x)InP layer 1183, and an n-type Al(x)InP layer 1184.

The Al(x)InP layer 1181, the p-type Ga(x)InP layer 1182, the n-type Ga(x)InP layer 1183, and the n-type Al(x)InP layer 1184 are deposited in this order on the surface of the tunnel junction layer 1170. In an actual manufacturing process, the GaInP cell 1180 is deposited on the GaAs contact layer 1040A on a GaAs substrate (not shown) in, for example, the upside-down state.

The GaInP cell 1180 includes crystal layers of GaInP which is in lattice matching with GaAs. In an actual manufacturing process, for example, the Al(x)InP layer 1184, the Ga(x)InP layer 1183, the Ga(x)InP layer 1182, and the Al(x)InP layer 1181 are deposited in this order.

The Al(x)InP layer 1181 is a Back Surface Field (BSF) layer disposed on the back side in the light incident direction. The pn junction of the GaInP cell 1180 is included in the Ga(x)InP layer 1182 and the Ga(x)InP layer 1183. The Al(x)InP layer 1184 is a window layer disposed on the front side (light incident side) in the light incident direction.

Here, the GaInP cell 1180 may be regarded as a cell having the Ga(x)InP layer 1182 and the Ga(x)InP layer 1183, which form the pn junction, the Al(x)InP layer 1184 formed on the light incident side of the GaInP cell 1180, and the Al(x)InP layer 1181 formed on the back side in the light incident direction.

The Al(x)InP layer 1181 is used as the BSF layer, and therefore the Al(x)InP layer 1181 has a band gap greater than the band gap (1.9 eV) of the p-type Ga(x)InP layer 1182 and the n-type Ga(x)InP layer 1183. As an impurity of the Al(x)InP layer 1181, for example, Zn may be used.

The conductive type of the Ga(x)InP layer 1182 becomes p-type by using, for example, Zn as an impurity.

The conductive type of the Ga(x)InP layer 1183 becomes n-type by using, for example, Si as an impurity.

The band gap of the Ga(x)InP layer 1182 and the Ga(x)InP layer 1183 is 1.9 eV.

The Al(x)InP layer 1184 is used as a window layer. Therefore, the Al(x)InP layer 1184 has a band gap greater than the band gap (1.9 eV) of the p-type Ga(x)InP layer 1182 and the n-type Ga(x)InP layer 1183.

In the fifth embodiment, the Al(x)InP layer 1184 has a band gap greater than the band gap (1.9 eV) of the p-type Ga(x)InP layer 1182 and the n-type Ga(x)InP layer 1183. As an impurity of the Al(x)InP layer 1184, for example, Si may be used.

The contact layer 1040A is a layer that is deposited on the GaInP cell 1180 to form ohmic contact with the electrode 1050. As the contact layer 1040A, for example, a gallium arsenide (GaAs) layer is used.

The electrode 1050 is a thin film made of a metal such as, for example, Ti/Pt/Au, and is formed on the contact layer 1040A.

Next, a method of manufacturing the compound semiconductor photovoltaic cell 1100 according to the fifth embodiment is described with reference to FIGS. 10A through 11B.

FIGS. 10A through 11B illustrate a method of manufacturing the compound semiconductor photovoltaic cell 1100 according to the fifth embodiment.

As shown in FIG. 10A, a layered body 1100A is formed by using a GaAs substrate 1020 and a layered body 1100B is formed by using the InP substrate 1110. The GaAs substrate 1020 is an example of a second compound semiconductor substrate.

Here, the GaInP cell 1180 included in the layered body 1100A includes crystal layers of GaInP which are in lattice matching with GaAs, and are formed on the GaAs substrate 1020. Further, the GaInPAs cell 1120 included in the layered body 1100B includes crystal layers of GaInPAs which are in lattice matching with InP and are formed on the InP substrate 1110.

As described above, the lattice constant of the layered body 1100A differs from that of the layered body 1100B. The compound semiconductor photovoltaic cell 100 according to the fifth embodiment is manufactured by directly bonding the layered body 1100A to the layered body 1100B having a lattice constant different from that of the layered body 1100A.

The lattice constant of InP is approximately 5.87 Å. Therefore, the composition of the GaInPAs cell 1120 formed on the InP substrate 1110 is adjusted in a manner such that the GaInPAs cell 1120 has a lattice constant very close to the lattice constant of InP (approximately 5.87 Å).

Further, the lattice constant of GaAs is approximately 5.65 Å. Therefore, the composition of the GaAs cell 1160 and the GaInP cell 1180 formed on the GaAs substrate 1020 is adjusted in a manner such that the GaAs cell 1160 and the GaInP cell 1180 have the lattice constants very close to the lattice constant of InP (approximately 5.65 Å).

The layered body 1100A is formed by depositing a Ga(x)InP etching stop layer 1030, an n+type GaAs contact layer 1040, the GaInP cell 1180, the tunnel junction layer 1170, the GaAs cell 1160, the tunnel junction layer 1150, and the bonding layer 1140 on the GaAs substrate 1020 by Metal Organic Chemical Vapor Deposition (MOCVD) method.

Here, the GaInP cell 1180 includes the Al(x)InP layer 1184 which is in lattice matching with GaAs, the Ga(x)InP layer 1183, the Ga(x)InP layer 1182, and the Al(x)InP layer 1181. The Al(x)InP layer 1181 is a BSF layer, and the Al(x)InP layer 1184 is a window layer.

The tunnel junction layer 1170 includes the Al(x)GaAs layer 1172 and the Ga(x)InP layer 1171.

The GaAs cell 1160 includes the [Al(x)Ga](y)InP layer 1164, the GaAs layer 1163, the GaAs layer 1162, and the Ga(x)InP layer 1161. The Ga(x)InP layer 1161 is a BSF layer, and the [Al(x)Ga](y)InP layer 1164 is a window layer.

Further, the tunnel junction layer 1150 includes the GaAs layer 1151 and the GaAs layer 1152.

In the deposition (growth) of the layered body 1100A, the lower side where the GaAs substrate 1020 exists is the light incident side, so that when the layered body 1100A is to be bonded to the layered body 1100B, the layered body 1100A is turned over to be upside down. In this regard, the layered body 1100A is grown downward in FIG. 9 which is opposite to the normal growing direction.

Specifically, the layers are sequentially grown from the cell having a wider band gap (i.e., GaInP cell 1180) to the cell having narrower band gap (i.e., GaAs cell 1160). But finally, the p side becomes the lower side (the back side in the light incident direction).

The layered body 1100B is formed by growing (depositing) the GaInPAs cell 1120 and the bonding layer 1130 on the InP substrate 1110 by the MOCVD method. In the layered body 1100B in FIG. 10A, the bonding layer 1130 side, which is opposite to the InP substrate 1110 side, is the light incident side.

The GaInPAs cell 1120 includes the InP layer 1121, the Ga(x)InP(y)As layer 1122, the Ga(x)InP(y)As layer 1123, and the [Al(x)Ga](y)InAs layer 1124 from the InP substrate 1110 side. The InP layer 1121 is a BSF layer and the [Al(x)Ga](y)InAs layer 1124 is a window layer.

By doing this, the layered body 1100A and the layered body 1100B are formed by epitaxial growth using the MOCVD method.

Next, as shown in FIG. 10B, the layered body 1100A and the layered body 1100B formed by epitaxial growth are directly bonded to each other.

A cleaning process and a surface activation process are performed on the surface of the bonding layer 1140 of the layered body 1100A and the surface of the bonding layer 1130 of the layered body 1100B, so that the bonding layer 1130 is directly bonded to the bonding layer 1140. As the surface activation process, a nitrogen (N₂) plasma process is performed in a vacuum at a temperature of 150 °C for the bonding.

By doing this, the layered body 1100C of FIG. 10B is formed. The layered body 1100C is formed by bonding the bonding layer 1140 of the layered body 1100A, which is turned over to be in the upside-down state, to the bonding layer 1130 of the layered body 1100B.

The layered body 1100C has a structure where the GaInPAs cell 1120, the bonding layer 1130, the bonding layer 1140, the tunnel junction layer 1150, the GaAs cell 1160, the tunnel junction layer 1170, the GaInP cell 1180, the GaAs contact layer 1040, the Ga(x)InP etching stop layer 1030, and the GaAs substrate 1020 are sequentially deposited on the InP substrate 1110.

Next, the GaAs substrate 1020 and the Ga(x)InP etching stop layer 1030 are selectively etched from the layered body 1100C of FIG. 10B to acquire the layered body 100D in FIG. 11A.

The etching of the GaAs substrate 1020 and the Ga(x)InP etching stop layer 1030 is performed as described below.

The etching of the GaAs substrate 1020 may be performed by, for example, using a mixture of sulfuric acid (H₂SO₄), hydrogen peroxide (H₂O₂), and water (H₂O) as a wet etching solution. The mixture of sulfuric acid (H₂SO₄), hydrogen peroxide (H₂O₂), and water (H₂O) does not dissolve GaInP of the Ga(x)InP etching stop layer 1030. Therefore, it becomes possible to stop the wet etching process by the Ga(x)InP etching stop layer 1030.

The Ga(x)InP etching stop layer 1030 may be etched by using, for example, a mixture of hydrochloric acid (HCl) and water (H₂O).

By doing this, the GaAs substrate 1020 and the Ga(x)InP etching stop layer 1030 can be etched from the layered body 1100C (see FIG. 10B) to form the layered body 1100D (see FIG. 11A).

Next, the upper electrode 1050 (see FIG. 9) is formed on the GaAs contact layer 1040, and the lower electrode 1010 is formed on the InP substrate 1110.

The contact layer 40A is formed by removing a part other than a part disposed just under the upper electrode 50 from the contact layer 40 (see FIG. 11A).

The contact layer 1040A may be formed by, for example, using a mixture of sulfuric acid (H₂SO₄), hydrogen peroxide (H₂O₂), and water (H₂O) as a wet etching solution. The mixture of sulfuric acid (H₂SO₄), hydrogen peroxide (H₂O₂), and water (H₂O) does not dissolve AlInP of the Al(x)InP layer 1184. Therefore, it becomes possible to stop the wet etching process by the Al(x)InP layer 1184 of the GaInP cell 1180.

By doing this, the compound semiconductor photovoltaic cell 1100 according to the fifth embodiment is formed. The compound semiconductor photovoltaic cell 1100 in FIG. 11B is the same as the compound semiconductor photovoltaic cell 1100 in FIG. 9.

The compound semiconductor photovoltaic cell 1100 has a structure where sunlight is incident on the wider-band-gap cell side (i.e., the GaInP cell 1180 side). It is preferable to dispose an antireflection film on the surface of the Al(x)InP layer 1184 where sunlight is incident. The antireflection film is omitted in FIG. 11B.

In the compound semiconductor photovoltaic cell 1100 according to the fifth embodiment, as the window layer of the GaInPAs cell 1120 formed on the InP substrate 1110, the [Al(x)Ga](y)InAs layer 1124 having a band gap of 1.5 eV is formed, and as the bonding layer 1130 formed on the GaInPAs cell 1120, an GaInP bonding layer is formed.

The GaInP bonding layer used as the bonding layer 1130 has a Ga composition of 10%, tensile strain of 0.7%, and a band gap of 1.42 eV. The band gap of the bonding layer 1130 (1.42 eV) is set so as to be greater than or equal to the band gap (1.42 eV) of the GaAs cell 1160 which is adjacent to the bonding layer 1130 on the light incident side in the light incident direction.

Namely, the Ga(x)InP layer used as the bonding layer 1130 has the band gap described above so as to guide light to the GaInPAs cell 1120 in the back side of the bonding layer 1130 in the light incident direction, the light being transmitted through the GaAs cell 1160, which is the photoelectric conversion cell adjacent to the bonding layer 1130 in the light incident (upstream) side in the light incident direction, without being absorbed by the GaAs cell 1160.

Further, due to a similar reason, the band gap of the tunnel junction layer 1150 and the bonding layer 1140 is set to be equal to that of the GaAs cell 1160.

In order to ensure the light transmitted through the bonding layer 1130 reaches the Ga(x)InP(y)As layer 1122 and the Ga(x)InP(y)As layer 1123 of the GaInPAs cell 1120, the band gap of the [Al(x)Ga](y)InAs layer 1124, which is the window layer of the GaInPAs cell 1120, is set to 1.5 eV which is greater than that of the GaAs cell 1160.

In a related technology, an InP layer (1.35 eV) is used as the bonding layer to bond wafers to each other.

Here, for example, if an InP layer is used as the bonding layer 1130 similar to a compound semiconductor photovoltaic cell in the related technology, a part of the light transmitted through the GaAs cell 1160 (1.42 eV) is absorbed because the band gap of InP is 1.35 eV.

When a part of sunlight transmitted through the GaAs cell 1160 (1.42 eV) is absorbed as described above, an energy loss occurs which is a cause of reduction of efficiency of the compound semiconductor photovoltaic cell.

On the other hand, in the compound semiconductor photovoltaic cell 1100 according to the fifth embodiment, in order to prevent the occurrence of the energy loss, the Ga(x)InP layer having a band gap greater than or equal to the band gap of the GaAs cell 1160, the tunnel junction layer 1150, and the bonding layer 1140 is used as the bonding layer 1130.

Therefore, according to the fifth embodiment, it becomes possible to provide the compound semiconductor photovoltaic cell 1100 where the efficiency is enhanced and a method of manufacturing the compound semiconductor photovoltaic cell 1100.

Further, in the compound semiconductor photovoltaic cell 1100 according to the fifth embodiment, in addition to the setting of the band gap of the bonding layer 1130 as described above, the band gap of the [Al(x)Ga](y)InAs layer 1124, which is the window layer of the GaInPAs cell 1120, is set to 1.5 eV which is greater than that of the GaAs cell 1160.

By doing this, it also becomes possible to provide the compound semiconductor photovoltaic cell 1100 where the efficiency is enhanced.

Further, in the above description, a case is described where the band gap of the tunnel junction layer 1150 and the bonding layer 1140 is the same as the band gap (1.42 eV) of the GaAs cell 1160. However, the band gap of the tunnel junction layer 1150 and the bonding layer 1140 may be greater than the band gap (1.42 eV) of the GaAs cell 1160.

In such a case, the band gap of the Ga(x)InP layer used as the bonding layer 1130 is greater than or equal to the band gap (1.42 eV) of the GaAs cell 1160.

When the band gap of the tunnel junction layer 1150 and the bonding layer 1140 is greater than the band gap (1.42 eV) of the GaAs cell 1160, the light transmitted through the GaAs cell 1160 is guided to the bonding layer 1130 including the GaInP layer without being absorbed by the tunnel junction layer 1150 and the bonding layer 1140.

Therefore, when the band gap of the bonding layer 1130 including the GaInP layer is greater than the band gap (1.42 eV) of the GaAs cell 1160, light is not absorbed by the bonding layer 1130 including the GaInP layer, so that the light transmitted through the tunnel junction layer 1150 and the bonding layer 1140 can be effectively guided to the GaInPAs cell 1120.

Further, the GaInP layer (the bonding layer 1130) having a tensile strain is formed thinner than that of the GaInP layer where lattice relaxation occurs.

Besides the GaInP having a tensile strain, as a material having a band gap greater than or equal to the band gap (1.42 eV) of the GaAs cell 1160 and capable of growing on the InP substrate 1110, GaPSb is used.

Therefore, as the bonding layer 1130, a GaPSb layer may be used in place of the GaInP layer described above. In this case, the composition is adjusted so that the GaPSb layer has a band gap greater than or equal to the band gap (1.42 eV) of the GaAs cell 1160.

Further, for example, Al(Ga)InAs, Al(Ga)AsSb, Al(Ga)PSb, and Al(In)Psb are the materials that have the compositions so as to have a band gap greater than or equal to that of the GaAs cell 1160 (1.42 eV) and that can grow on the InP substrate 1110.

Therefore, a thin film formed of, for example, Al(Ga)InAs, Al(Ga)AsSb, Al(Ga)PSb, or Al(In)PSb may be used in place of the [Al(x)Ga](y)InAs layer 1124 which is the window layer of the GaInPAs cell 1120.

In this case, the composition is adjusted so that the band gap of the thin film formed of, for example, Al(Ga)InAs, Al(Ga)AsSb, Al(Ga)PSb, or Al(In)PSb used in place of the [Al(x)Ga](y)InAs layer 1124 is greater than or equal to that of the GaAs cell 1160 (1.42 eV).

Here, the expression "(Ga)" is used because each of the compositions of Al(Ga)InAs, Al(Ga)AsSb, and Al(Ga)PSb may include Ga or may not include Ga. Namely, "Al(Ga)InAs" denotes AlGaInAs and AlInAs, "Al(Ga)AsSb" denotes AlGaAsSb and AlAsSb, and "Al(Ga)PSb" denotes AlGaPSb and AlPSb.

Here, the expression "(In)" is used because the composition Al(In)PSb may include In or may not include In. Namely, "Al(In)PSb" denotes AlInPSb and AlPSb.

In a triple-junction photovoltaic cell such as the compound semiconductor photovoltaic cell 1100 according to the fifth embodiment, OYO BUTURI Vol.79, No. 5, 2010 page 436 describes that as the combination of the band gaps of the three cells, values "1.9 eV/1.42 eV/1.0 eV" and "1.7 eV/1.2 eV/0.67 eV" are preferable to the values "1.88 eV/1.4 eV/0.67 eV" of a triple-junction photovoltaic cell in the related technology.

However, it is difficult to have such combination band gap as described above with a single lattice constant.

In this regard, according to the fifth embodiment, the compound semiconductor photovoltaic cell 1100 is formed by bonding two cells having different lattice constants (i.e., the layered body 1100A and the layered body 1100B, see FIG. 10A) using a direct bonding method. By doing this, it becomes easier to form the compound semiconductor photovoltaic cell 1100 including cells having different lattice constants.

In the above description, a case is described where cells are formed on the InP substrate 1110 and the GaAs substrate 1020 by MOCVD method. However, the cell may be formed by Molecular Beam Epitaxy (MBE) method.

Also, in the above description, a case is described where the compound semiconductor photovoltaic cell 1100 is formed by using the layered body 1100A and the layered body 1100B using the InP substrate 1110 and the GaAs substrate 1020, respectively. However, any combination other than the combination of the InP substrate 1110 and the GaAs substrate 1020 may be used.

For example, any of the combinations including, for example, Ge substrate and InP substrate, GeSb substrate and GaAs substrate, GaSb substrate and Ge substrate, Si substrate and Ge substrate, and Si substrate and GaAs substrate may be used to form the layered body 1100B and the layered body 1100A.

Further, in the above description, a case is described where the layered bodies 1100A and 1100B are directly bonded. However, the layered bodies 1100A and 1100B may be mechanically bonded as shown in FIG. 12.

Further, in the above description, a case is described where the GaInPAs cell 1120 is used as the InP lattice matching based material cell. However, the InP lattice matching based material cell is not limited to the GaInPAs cell 1120. For example, a cell expressed in GaIn(P)As may be used.

Here, the expression "(P)" is used because the composition GaIn(P)As may include P or may not include P. Namely, "GaIn(P)As" denotes GaInPAs and GaInAs. Therefore, a GaInAs cell may be used in place of the GaInPAs cell 1120.

Further, in the above description, a case is described where the GaInP cell 1180 is used as the GaAs lattice matching based material cell. However, the GaAs lattice matching based material cell is not limited to the GaInP cell 1180. A cell expressed in (Al)GaInP(As) may be used.

Here, the expressions "(Al)" and "(As)" are used because the composition (Al)GaInP(As) may include Al or may not include Al and may include Al and may not include As. Namely, "(Al)GaInP(As)" denotes AlGaInP, GaInPAs, and GaInP. Therefore, an AlGaInP cell or a GaInPAs cell may be used in place of the GaInP cell 1180.

FIG. 12 is a cross-sectional view of a compound semiconductor photovoltaic cell 1101 according to a first modified example of the fifth embodiment.

In the compound semiconductor photovoltaic cell 1101 according to the first modified example of the fifth embodiment, the bonding layer 1130 and the bonding layer 1140 of FIG. 9 are mechanically bonded to each other.

In the compound semiconductor photovoltaic cell 1101 of FIG. 12, the bonding layer 1130 and the bonding layer 1140 are bonded via a fixing member 1102. As the fixing member 1102, a Pd Nanoparticle Array may be used.

The Pd Nanoparticle Array is for causing conductive nanoparticles to be self-arranged on the junction interface, with the use of the separation arrangement of a block copolymer. Nano arrangements of Pd, Au, Pt, Ag, etc., are possible. A diluted solution of a block copolymer is spin-coated, the block copolymer is caused to be self-arranged, and the block copolymer is exposed to an aqueous solution including metal ions such as Pd²+ (palladium ions), so that metal ions are selectively formed in the block copolymer. Then, Ar (argon) plasma is radiated, so that the block copolymer template is removed, and a nanoparticle array which is self-arranged, is formed. Light is transmitted through parts without nanoparticles. By using a palladium nanoparticle array, light that has been transmitted through the GaAs cell 1160 can be efficiently guided to the GaInPAs cell 1120.

With the Pd Nanoparticle Array formed on either the bonding layer 1130 or the bonding layer 1140, the bonding layer 1130 and the bonding layer 1140 are bonded to each other to form the compound semiconductor photovoltaic cell 1101.

The fixing member 1102 is an example of a fixing unit. The method of mechanically bonding two layered bodies with the fixing member 1102 is called "mechanical stack".

The fixing member 1102 is not limited to the Pd Nanoparticle Array. For example, the fixing member 1102 may be a Nanoparticle Array including another metal (e.g., Au) or may be another mechanical means.

The compound semiconductor photovoltaic cell 1101 includes surface layers 1130A and 1140A in place of the bonding layers 1130 and 1140. The surface layers 1130A and 1140A are similar to the bonding layers 1130 and 1140 but are not directly bonded to each other. Therefore, those layers are called "surface layers 1130A and 1140A" in FIG. 12.

As described above, in the compound semiconductor photovoltaic cell 1101, the bonding layers 1130 and 1140 are bonded with the fixing member 1102. Therefore, it is not necessary to include the tunnel junction layer 1150 (see FIG. 9) between the GaAs cell 1160 and the bonding layer 1140, so that the GaAs cell 1160 is directly bonded to the bonding layer 1140.

As described above, the layered body including the GaInPAs cell 1120 may be bonded to the layered body including the GaAs cell 1160 and the GaInP cell 1180 by mechanical stack.

Further, the compound semiconductor photovoltaic cell 1100 according to the fifth embodiment may also be modified as shown in FIG. 13.

FIG. 13 is a cross-sectional view of a compound semiconductor photovoltaic cell 1103 according to a second modified example of the fifth embodiment.

The compound semiconductor photovoltaic cell 1103 according to the second modified example of the fifth embodiment includes the electrode 1010, the InP substrate 1110, the GaInPAs cell 1120, the bonding layer 1130, the tunnel junction layer 1150A, the GaAs cell 1160, the tunnel junction layer 1170, the GaInP cell 1180, the contact layer 1040A, and the electrode 1050.

In the compound semiconductor photovoltaic cell 1103, the bonding layer 1140 and the n+type GaAs layer 1151 are removed from the compound semiconductor photovoltaic cell 1100, so that the bonding layer 1130 is directly bonded to the p+type GaAs layer 1152. The tunnel junction layer 1150A in FIG. 13 is similar to the p+type GaAs layer 1152 in FIG. 9. In such a compound semiconductor photovoltaic cell 1103, a tunnel junction is formed between the bonding layer 1130 and the tunnel junction layer 1150A.

In the compound semiconductor photovoltaic cell 1100 according to the fifth embodiment of FIG. 9, when the band gap of the tunnel junction layer 1150 and the bonding layer 1140 is greater than or equal to the band gap (1.42 eV) of the GaAs cell 1160, the light transmitted through the GaAs cell 1160 is guided to the bonding layer 1130 without being absorbed by the tunnel junction layer 1150 and the bonding layer 1140.

However, even in a case where light can be absorbed by the GaAs cell 1160 due to the wavelength, if the GaAs cell 1160 disposed on the light incident side of the tunnel junction layer 1150 and serving as an absorbing layer is thin, so that the incident light cannot be sufficiently absorbed, the light transmitted through the GaAs cell 1160 is absorbed by the tunnel junction layer 1150 and the bonding layer 1140, thereby affecting the efficiency.

Further, in a case of a multi-junction photovoltaic cell having multiple cells, in order to equalize the values of the currents that can be drawn from the multiple cells, any of the multiple cells may be thinly formed so that light having an absorbable wavelength can be transmitted therethrough and the cell in the back side in the light incident direction can absorb the light. Further, it is desired that the overall thickness of the multi-junction photovoltaic cell be reduced as much as possible.

Therefore, by removing the bonding layer 1140 and the n+type GaAs layer 1151 of FIG. 9 so that the tunnel junction is formed by the bonding layer 1130 and the tunnel junction layer 1150A as shown in FIG. 13, it becomes possible to provide the compound semiconductor photovoltaic cell 1103 capable of reducing light absorption more than and having less thickness than the compound semiconductor photovoltaic cell 1100 of FIG. 9.

In the fifth embodiment, a triple-junction type compound semiconductor photovoltaic cell 1100 including the GaInP cell 1180, the GaAs cell 1160, and the GaInPAs cell 1120 is formed. The combination of the band gaps of the three photoelectric conversion cells thereof is 1.9 eV/1.42 eV/1.0 eV

### Sixth embodiment:

In a sixth embodiment, by adding a GaInAs cell (0.75 eV) to the GaInP cell 1180, the GaAs cell 1160, and the GaInPAs cell 1120, a quad-junction type compound semiconductor photovoltaic cell 1200 is provided. The combination of the band gaps of the four photoelectric conversion cells thereof is 1.9 eV/1.42 eV/1.0 eV/0.75 eV.

FIG. 14 is a cross-sectional view of the compound semiconductor photovoltaic cell 1200 according to the sixth embodiment. In the following, the same reference numerals are repeatedly used to describe the same constituent elements as those in the compound semiconductor photovoltaic cell 1100 in the fifth embodiment, and the repeated descriptions thereof may be omitted.

The compound semiconductor photovoltaic cell 1200 includes the electrode 1010, the InP substrate 1110, a GaInAs cell 1210, a tunnel junction layer 1220, the GaInPAs cell 1120, the bonding layer 1130, the bonding layer 1140, the tunnel junction layer 1150, the GaAs cell 1160, the tunnel junction layer 1170, the GaInP cell 1180, the contact layer 1040A, and the electrode 1050.

The compound semiconductor photovoltaic cell 1200 according to the sixth embodiment is a quad-junction photovoltaic cell in which the GaInAs cell 1210 (0.75 eV), the GaInPAs cell 1120 (1.0 eV), the GaAs cell 1160 (1.42 eV), the GaInP cell 1180 (1.9 eV) are connected in series.

Here, the GaInAs cell 1210 and the GaInPAs cell 1120 are examples of multiple first photoelectric conversion cells which are formed of a first compound semiconductor material.

In FIG. 14, light is incident in the direction from the upper side to the lower side in the figure (i.e., in the direction from the GaInP cell 1180 to the GaInAs cell 1210).

IEEE Document (Processing of the 28th IEEE Photovoltaic Specialists Conference (2009) pp. 1090-1093) describes that it is preferable for a quad-junction photovoltaic cell to have a band gap balance of a combination approximately 1.9 eV/1.4 eV/1.0 eV/0.7 eV.

In the compound semiconductor photovoltaic cell 1200, the GaInAs cell 1210 and a tunnel junction layer 1220 are formed between the InP substrate 1110 and the GaInPAs cell 1120 of the compound semiconductor photovoltaic cell 1100 according to the fifth embodiment.

The GaInAs cell 1210 includes a p-type InP layer 1211, a p-type Ga(x)InAs layer 1212, an n-type Ga(x)InAs layer 1213, and an n-type InP layer 1214. The InP layer 1211 is a BSF layer, and the InP layer 1214 is a window layer.

Here, the GaInAs cell 1210 may be regarded as a cell which does not include the InP layer 1211 and the InP layer 1214 so as to include only the Ga(x)InAs layer 1212 and the Ga(x)InAs layer 1213. In this case, it is assumed that the InP layer 1214 is formed on the light incident side of the GaInAs cell 1210 including the Ga(x)InAs layer 1212 and the Ga(x)InAs layer 1213 and the InP layer 1211 is formed on the back side of the GaInAs cell 1210 in the light incident direction.

The band gap of the p-type Ga(x)InAs layer 1212 and the n-type Ga(x)InAs layer 1213 is 0.75 eV.

The tunnel junction layer 1220 is formed between the GaInPAs cell 1120 and the GaInAs cell 1210. The tunnel junction layer 1220 includes an n+type InP layer 1221 and a p+type Al(x)InAs layer 1222.

As the impurity to set the conductive type of the InP layer 1221 to n+type, for example, silicon (Si) may be used. As the impurity to set the conductive type of the Al(x)InAs layer 1222 to p+type, for example, carbon (C) may be used. The n+type InP layer 1221 and the p+type Al(x)InAs layer 1222 include a thin pn junction doped in high concentration.

The n+type InP layer 1221 and the p+type Al(x)InAs layer 1222 of the tunnel junction layer 1220 are doped with higher concentration than the GaInPAs cell 1120. The tunnel junction layer 1220 is a junction layer which is formed in order to flow current between the p-type Ga(x)InP(y)As layer 1122 of the GaInPAs cell 1120 and the n-type Ga(x)InAs layer 1213 of the GaInAs cell 1210 (by tunnel junction).

The compound semiconductor photovoltaic cell 1200 according to the sixth embodiment has a combination of band gaps 1.9 eV/1.42 eV/ 1.0 eV/0.75 eV by the four photoelectric conversion cells which are the GaInP cell 1180, the GaAs cell 1160, the GaInPAs cell 1120, and the GaInAs cell 1210.

Therefore, according to the sixth embodiment, it becomes possible to provide the compound semiconductor photovoltaic cell 1200 having higher energy conversion efficiency than the compound semiconductor photovoltaic cell 1100 according to the fifth embodiment.

Further, similar to the case of the second modified example of the fifth embodiment, the thickness of the compound semiconductor photovoltaic cell 1200 of FIG. 14 may be reduced and the light absorption may be reduced than the compound semiconductor photovoltaic cell 1200 of FIG. 14 by removing the bonding layer 1140 and the n+type GaAs layer 1151 to form the tunnel junction by the bonding layer 1130 and the p+type GaAs layer 1152.

### Seventh embodiment:

FIG. 15 is a cross-sectional drawing of a compound semiconductor photovoltaic cell 1300 according to a seventh embodiment.

In the compound semiconductor photovoltaic cell 1300 according to the seventh embodiment, a GaInAs cell (1.40 eV) having an In composition of 1.5% and a distortion (strain) of 0.1% is used in place of the GaAs cell 1160 (1.42eV) in the compound semiconductor photovoltaic cell 1100 according to the fifth embodiment.

Further, in the compound semiconductor photovoltaic cell 1300 according to the seventh embodiment, the bonding layer 1130 and the [Al(x)Ga](y)InAs layer 1124 in the compound semiconductor photovoltaic cell 1100 according to the fifth embodiment (FIG. 9) are replaced by the bonding layer 1330 and a Ga(x)InP layer 1324, respectively.

The compound semiconductor photovoltaic cell 1300 according to the seventh embodiment includes the electrode 1010, the InP substrate 1110, a GaInPAs cell 1320, the bonding layer 1330, the bonding layer 1140, the tunnel junction layer 1150, the GaInAs cell 1360, the tunnel junction layer 1170, the GaInP cell 1180, the contact layer 1040A, and the electrode 1050.

Here, the GaInPAs cell 1320 is an InP based photoelectric conversion cell, and the GaInAs cell 1360 is a GaAs based photoelectric conversion cell.

The GaInPAs cell 1320 includes the InP layer 1121, the Ga(x)InP(y)As layer 1122, the Ga(x)InP(y)As layer 1123, and a Ga(x)InP layer 1324. Namely, in the GaInPAs cell 1320, the [Al(x)Ga](y)InAs layer 1124 of the GaInPAs cell 1120 in the fifth embodiment is replaced by the Ga(x)InP layer 1324. The band gap of the Ga(x)InP layer 1324 is 1.40 eV.

As the bonding layer 1330, a GaInP layer having a Ga composition of 7% and having a tensile strain of 0.5% is used. The band gap of the GaInP layer is 1.40 eV. Namely, the bonding layer 1330 is a layer having a Ga composition less than that of the bonding layer 1130 (having a Ga composition of 10%) in the fifth embodiment.

The GaInAs cell 1360 includes the p-type Ga(x)InP layer 1161, a p-type Ga(x)InAs layer 1362, a n-type Ga(x)InAs layer 1363, and the n-type [Al(x)Ga](y)InP layer 1164.

In the GaInAs cell 1360, the pn layer for photoelectric conversion of the GaAs cell 1160 (FIG. 9) is replaced by the Ga(x)InAs layer 1362 and the Ga(x)InAs layer 1363 which have a In composition of 1.5%, a distortion (strain) of 0.1%, and a band gap of 1.40 eV.

When the GaInAs cell 1360 has a distortion (strain) of approximately 0.1% relative to the GaAs substrate 1020, the GaInAs cell 1360 can grow to have a sufficient thickness as an absorbing layer.

In the compound semiconductor photovoltaic cell 1300 according to the seventh embodiment, the Ga(x)InP layer 1324 having a band gap of 1.4 eV is formed as the window layer of the GaInPAs cell 1320 formed on the InP substrate 1110, and the GaInP bonding layer having a band gap of 1.40 eV is formed as the bonding layer 1330 formed thereon.

The GaInP bonding layer formed as the bonding layer 1330 has a Ga composition of 7% and has a tensile strain of 0.5%. The band gap of the GaInP bonding layer is 1.40 eV. The band gap (1.40 eV) of the bonding layer 1330 is set to be greater than or equal to the band gap of the (1.40 eV) of the GaInAs cell 1360 which is a photoelectric conversion cell adjacent to the bonding layer 1330 on the light incident side.

Namely, the Ga(x)InP layer used as the bonding layer 1330 has the above-described band gap so that the light transmitted through the GaInAs cell 1360, which is the adjacent photoelectric conversion cell disposed on the light incident side (the upstream side) in the light incident direction, without being absorbed therein, is guided to the GaInPAs cell 1320 disposed on the back side thereof in the light incident direction.

Further, the band gap of the tunnel junction layer 1150 and the bonding layer 1140 is 1.42 eV which is greater than the band gap (1.40 eV) of the GaInAs cell 1360.

Further, in order to ensure that the light transmitted through the bonding layer 1330 reaches the Ga(x)InP(y)As layer 1122 and the Ga(x)InP(y)As layer 1123 of the GaInPAs cell 1320, the band gap of the Ga(x)InP layer 1324, which is the window layer of the GaInPAs cell 1320, is set to 1.40 eV which is equal to the band gap of the GaInAs cell 1360.

In a related technology, an InP layer (1.35 eV) is used as the bonding layer to bond wafers.

Here, for example, similar to a compound semiconductor photovoltaic cell in a related technology, when an InP layer is used as the bonding layer 1330, since the band gap of InP is 1.35 eV, a part of sunlight transmitted through the GaInAs cell 1360 (1.40 eV) is absorbed.

When a part of sunlight transmitted through the GaInAs cell 1360 (1.40 eV) is absorbed by the InP layer, an energy loss occurs which is a cause of reduction of efficiency of the compound semiconductor photovoltaic cell.

On the other hand, in the compound semiconductor photovoltaic cell 1300 according to the seventh embodiment, in order to prevent the occurrence of the energy loss, the Ga(x)InP layer having a band gap equal to that of the GaInAs cell 1360 is used as the bonding layer 1330.

By doing this, according to the seventh embodiment, it becomes possible to provide the compound semiconductor photovoltaic cell 1300 having a higher efficiency and a method of manufacturing the compound semiconductor photovoltaic cell 1300.

Further, in the compound semiconductor photovoltaic cell 1300 according to the seventh embodiment, in addition to the setting of the band gap of the bonding layer 1330 as described above, the band gap of the GaInAs layer 1324, which is the window layer of the GaInPAs cell 1320, is set to 1.40 eV which is equal to that of the GaInAs cell 1360.

By doing this, it also becomes possible to provide the compound semiconductor photovoltaic cell 1300 where the efficiency is enhanced.

Further, similar to the case of the second modified example of the fifth embodiment, the thickness of the compound semiconductor photovoltaic cell 1300 of FIG. 15 may be reduced and the light absorption may be reduced by removing the bonding layer 1140 and the n+type GaAs layer 1151 to form the tunnel junction by the bonding layer 1130 and the p+type GaAs layer 1152.

Further, in the seventh embodiment, a case is described where as the cell on the side where the band gap is greater, a GaAs lattice matching based material grows on the GaAs substrate 1020. However, a Germanium (Ge) substrate may be used in place of the GaAs substrate 1020 and a Ge lattice matching based material may grow on the Ge substrate.

In this case, although the lattice constant of Ge is slightly greater than that of the GaAs, for example, a composition of the material to be formed on the GaAs substrate may be modified for lattice matching. Especially, the In composition of the GaInAs to be in lattice matching with Ge is approximately 1%. Therefore, the GaInAs cell 1360 having an In composition of 1.5% in the seventh embodiment can more easily crystal-grow on the Ge substrate than on the GaAs substrate.

### Eighth embodiment

FIG. 16 is a cross-sectional view of a compound semiconductor photovoltaic cell 1400 according to an eighth embodiment of the present invention.

The compound semiconductor photovoltaic cell 1400 according to the eighth embodiment is a quad-junction photovoltaic cell which is formed by forming the GaInAs cell 1210 and the tunnel junction layer 1220 between the InP substrate 1110 and the GaInPAs cell 1320 of the compound semiconductor photovoltaic cell 1300 according to the seventh embodiment.

This relationship is similar to the relationship in which the quad-junction-type compound semiconductor photovoltaic cell 1200 according to the sixth embodiment is formed by forming the GaInAs cell 1210 and the tunnel junction layer 1220 between the InP substrate 1110 and the GaInPAs cell 1120 of the compound semiconductor photovoltaic cell 1100 according to the fifth embodiment.

In the following, the same reference numerals are repeatedly used to describe the same constituent elements as those in the fifth through seventh embodiments, and the repeated descriptions thereof may be omitted.

The compound semiconductor photovoltaic cell 1400 according to the eighth embodiment includes the electrode 1010, the InP substrate 1110, the GaInAs cell 1210, the tunnel junction layer 1220, the GaInPAs cell 1320, the bonding layer 1330, the bonding layer 1140, the tunnel junction layer 1150, the GaInAs cell 1360, the tunnel junction layer 1170, the GaInP cell 1180, the contact layer 1040A, and the electrode 1050.

The combination of the band gaps of the GaInP cell 1180, the GaInAs cell 1160, the GaInAs cell 1360, and the GaInAs cell 1210 which are four photoelectric conversion cells thereof is 1.9 eV/1.40 eV/1.0 eV/0.75 eV.

The compound semiconductor photovoltaic cell 1400 according to the eighth embodiment is a quad-junction photovoltaic cell in which the GaInAs cell 1210 (0.75 eV), the 1GaInPAs cell 1320 (1.0 eV), the GaInAs cell 1360 (1.40 eV), and the GaInP cell 1180 (1.9 eV) are connected in series.

In FIG. 16, light is incident in the direction from the upper side to the lower side in the figure (i.e., in the direction from the GaInP cell 1180 to the GaInAs cell 1210).

The compound semiconductor photovoltaic cell 1400 according to the eighth embodiment has a combination of band gaps 1.9 eV/1.40 eV/ 1.0 eV/0.75 eV by the four photoelectric conversion cells which are the GaInP cell 1180, the GaInAs cell 1360, the GaInPAs cell 1320, and the GaInAs cell 1210.

Therefore, according to the eighth embodiment, it becomes possible to provide the compound semiconductor photovoltaic cell 1400 having higher energy conversion efficiency than the compound semiconductor photovoltaic cell 1300 according to the seventh embodiment.

Further, similar to the case of the second modified example of the fifth embodiment, the thickness of the compound semiconductor photovoltaic cell 1400 of FIG. 16 may be reduced and the light absorption may be reduced by removing the bonding layer 1140 and the n+type GaAs layer 1151 to form the tunnel junction by the bonding layer 1130 and the p+type GaAs layer 1152.

Further, in the eighth embodiment, a case is described where as the cell on the side where the band gap is greater, a GaAs lattice matching based material grows on the GaAs substrate 1020. However, a Germanium (Ge) substrate may be used in place of the GaAs substrate 1020 and a Ge lattice matching based material may grow on the Ge substrate.

In this case, although the lattice constant of Ge is slightly greater than that of the GaAs, for example, a composition of the material to be formed on the GaAs substrate may be modified for lattice matching. Especially, the In composition of the GaInAs to be in lattice matching with Ge is approximately 1%. Therefore, the GaInAs cell 1360 having an In composition of 1.5% in the seventh embodiment can more easily crystal-grow on the Ge substrate than on the GaAs substrate.

As described above, the compound semiconductor photovoltaic cells and the methods of manufacturing the compound semiconductor photovoltaic cells according to embodiments are described. However, the present invention is not limited to the embodiments specifically described and variations and modifications may be made without departing from the scope of the present invention as defined by the appended claims.

### DESCRIPTION OF TIIE REFERENCE NUMERALS

100: COMPOUND SEMICONDUCTOR PHOTOVOLTAIC CELL
10: ELECTRODE
20: GaAs SUBSTRATE
30: InP ETCHING STOP LAYER
40: GaAs CONTACT LAYER
40A: CONTACT LAYER
50: ELECTRODE
110: InP SUBSTRATE
120: GaInAs CELL
130: BONDING LAYER
140: BONDING LAYER
150: TUNNEL JUNCTION LAYER
160: GaInAs CELL
170: TUNNEL JUNCTION LAYER
180: GaInP CELL
200: COMPOUND SEMICONDUCTOR PHOTOVOLTAIC CELL
210: GaInAs CELL
220: TUNNEL JUNCTION LAYER
300: COMPOUND SEMICONDUCTOR PHOTOVOLTAIC CELL
320: GaInPAs CELL
330: BONDING LAYER
400: COMPOUND SEMICONDUCTOR PHOTOVOLTAIC CELL
1100: COMPOUND SEMICONDUCTOR PHOTOVOLTAIC CELL
1010: ELECTRODE
1020: GaAs SUBSTRATE
1030: InP ETCHING STOP LAYER
1040: GaAs CONTACT LAYER
1040A: CONTACT LAYER
1050: ELECTRODE
1110: InP SUBSTRATE
1120: GaInAs CELL
1130: BONDING LAYER
1140: BONDING LAYER
1150: TUNNEL JUNCTION LAYER
1160: GaInAs CELL
1170: TUNNEL JUNCTION LAYER
1180: GaInP CELL
1200: COMPOUND SEMICONDUCTOR PHOTOVOLTAIC CELL
1210: GaInAs CELL
1220: TUNNEL JUNCTION LAYER
1300: COMPOUND SEMICONDUCTOR PHOTOVOLTAIC CELL
1320: GaInPAs CELL
1330: BONDING LAYER
1400: COMPOUND SEMICONDUCTOR PHOTOVOLTAIC CELL

### PRIOR ART DOCUMENTS

### Non-Patent Documents

Non-Patent Document 1: Proceedings of the 35th IEEE Photovoltaic Specialists Conference (2010) pp.412-417.
Non-Patent Document 2: Applied Physics letters, 101,191111 (2012).
Non-Patent Document 3: Applied Physics letters, 89,102106 (2006).

### Patent Documents

Patent Document 1: Japanese Laid-Open Patent Publication No. 2002-289884.
Patent Document: US Patent Application Publication No. 2012/0138116.

## Claims

1. A compound semiconductor photovoltaic cell (300, 400, 1100, 1103, 1200, 1300, 1400) comprising:
a compound semiconductor substrate being an InP substrate (110, 1110);
one or more first photoelectric conversion cells (320, 1120, 1320) made of a first compound semiconductor material and deposited on the compound semiconductor substrate (110, 1110);
a bonding layer (330, 1130, 1330) made of a second compound semiconductor material and deposited on the one or more first photoelectric conversion cells (320, 1120, 1320); and
one or more second photoelectric conversion cells (160, 1160, 1360) made of a third compound semiconductor material, bonded to the one or more first photoelectric conversion cells (320, 1120, 1320) via the bonding layer (330, 1130, 1330), and disposed on a light incident side of the one or more first photoelectric conversion cells (320, 1120, 1320) in a light incident direction,
wherein band gaps of the one or more first photoelectric conversion cells (320, 1120, 1320) and the one or more second photoelectric conversion cells (160, 1160, 1360) decrease as the first and the second photoelectric conversion cells approach from the light incident side toward a back side in the light incident direction,
wherein, when a number of the one or more second photoelectric conversion cells (160, 1160, 1360) is one, a band gap of the bonding layer is greater than or equal to the band gap of the one second photoelectric conversion cell, and, when a number of the one or more second photoelectric conversion cells (160, 1160, 1360) is more than one, the band gap of the bonding layer is greater than or equal to the band gap of at least one of the second photoelectric conversion cells (160, 1160, 1360),
wherein the first photoelectric conversion cell (320, 1120, 1320), which is disposed in the most front side in the light incident direction among the one or more first photoelectric conversion cells, is an InP based photoelectric conversion cell,
wherein the second photoelectric conversion cell, which is disposed in the most back side in the light incident direction among the one or more second photoelectric conversion cells (160, 1160, 1360), is a GaAs based photoelectric conversion cell, and
wherein the bonding layer is made of GaInP or GaPSb having a tensile strain relative to the InP substrate (110, 1110).

2. A compound semiconductor photovoltaic cell (1101) comprising:
a compound semiconductor substrate being an InP substrate (1110);
one or more first photoelectric conversion cells (1120) made of a first compound semiconductor material and deposited on the compound semiconductor substrate;
a surface layer (1130A) made of a second compound semiconductor material and deposited on the one or more first photoelectric conversion cells;
one or more second photoelectric conversion cells (1160) made of a third compound semiconductor material, disposed on a light incident side of the surface layer (1130A) and the one or more first photoelectric conversion cells (1120) in a light incident direction, and separated from the surface layer (1130A) by a distance; and
a nanoparticle array (1102) that bonds a layered body of the one or more first photoelectric conversion cells (1120) and the surface layer (1130A) to the one or more second photoelectric conversion cells (1160),
wherein band gaps of the one or more first photoelectric conversion cells (1120) and the one or more second photoelectric conversion cells (1160) decrease as the first and the second photoelectric conversion cells (1160) approach from the light incident side toward a back side in the light incident direction,
wherein, when a number of the one or more second photoelectric conversion cells (1160) is one, a band gap of the surface layer (1130A) is greater than or equal to a band gap of the one second photoelectric conversion cell, and, when a number of the one or more second photoelectric conversion cells (1160) is more than one, the band gap of the surface layer (1130A) is greater than or equal to the band gap of at least one of the second photoelectric conversion cells (1160), and
wherein the first photoelectric conversion cell (1120), which is disposed in the most front side in the light incident direction among the one or more first photoelectric conversion cells, is an InP based photoelectric conversion cell,
wherein the second photoelectric conversion cell, which is disposed in the most back side in the light incident direction among the one or more second photoelectric conversion cells (1160), is a GaAs based photoelectric conversion cell,
wherein the surface layer (130A) is made of GaInP or GaPSb having a tensile strain relative to the InP substrate (1110).

3. The compound semiconductor photovoltaic cell (300, 400, 1100, 1103, 1200, 1300, 1400) according to claim 1,
wherein the band gap of the bonding layer is greater than or equal to a band gap of the second photoelectric conversion cell which is adjacent to the bonding layer on the light incident direction.

4. The compound semiconductor photovoltaic cell (300, 400, 1100, 1103, 1200, 1300, 1400) according to claim 1,
wherein the bonding layer (330, 1130, 1330, 1330A) forms a tunnel junction between the one or more second photoelectric conversion cells (360, 1160, 1360) and the one or more first photoelectric conversion cells (320, 1120, 1320), the one or more second photoelectric conversion cells (360, 1160, 1360) being adjacent to the bonding layer (330, 1130, 1330, 1330A) and disposed on the light incident side of the bonding layer (330, 1130, 1330, 1330A) in the light incident direction, the one or more first photoelectric conversion cells (320, 1120, 1320) being adjacent to the bonding layer (330, 1130, 1330, 1330A) and disposed on the back side of the bonding layer (330, 1130, 1330, 1330A) in the light incident direction.

5. The compound semiconductor photovoltaic cell (300, 400, 1100, 1101, 1103, 1200, 1300, 1400) according to any one of claims 1 through 4,
wherein the one or more first photoelectric conversion cells (320, 1120, 1320) include a window layer (324, 1124, 1324) disposed on the light incident side in the light incident direction, the window layer (324, 1124, 1324) having a band gap greater than or equal to a band gap of a second photoelectric conversion cell (360, 1160, 1360), which is disposed in the most back side in the light incident direction among the one or more second photoelectric conversion cells (360, 1160, 1360).

6. The compound semiconductor photovoltaic cell (300, 400, 1100, 1103, 1200, 1300, 1400) according to claim 5,
wherein the window layer (324, 1124, 1324) is made of any one of GaInP, GaPSb, Al(Ga)InAs, Al(Ga)AsSb, Al(Ga)PSb, and Al(In)PSb.

7. The compound semiconductor photovoltaic cell (300, 400, 1100, 1101, 1103, 1200, 1300, 1400) according to any one of claims 1 through 6,
wherein the one or more second photoelectric conversion cells (1160, 1360) include a GaInAs cell having a compressive strain relative to a GaAs substrate.

8. The compound semiconductor photovoltaic cell (300, 400, 1100, 1101, 1103, 1200, 1300, 1400) according to any one of claims 1 through 7,
wherein the compound semiconductor photovoltaic cell (300, 400, 1100, 1101, 1103, 1200, 1300, 1400) is a multi-junction cell consisting of at least three photoelectric conversion cells, which are optically bonded in series in the laminating direction, based on the one or more first photoelectric conversion cells (320, 1120, 1320) the one or more second photoelectric conversion cells (360, 1160, 1360).

9. The compound semiconductor photovoltaic cell (300, 400, 1100, 1101, 1103, 1200, 1300, 1400) according claim 8, further comprising:
a GaAs or Ge lattice matching based material cell including (Al)GaInP(As); and
an InP lattice matching based material cell including GaIn(P)As.

10. The compound semiconductor photovoltaic cell (1101) according to claim 2, wherein the band gap of the surface layer (1130A) is greater than or equal to a band gap of the second photoelectric conversion cell (1160) which is adjacent to the surface layer (1130A) in the light incident direction.

## Patentansprüche

1. Verbindungshalbleiter-Fotovoltaikzelle (300, 400, 1100, 1103, 1200, 1300, 1400), umfassend:
ein Verbindungshalbleitersubstrat, das ein InP-Substrat (110, 1110) ist;
eine oder mehrere erste fotoelektrische Umwandlungszellen (320, 1120, 1320), die aus einem ersten Verbindungshalbleitermaterial bestehen und auf dem Verbindungshalbleitersubstrat (110, 1110) abgeschieden sind;
eine Bondschicht (330, 1130, 1330), die aus einem zweiten Verbindungshalbleitermaterial besteht und auf der einen oder den mehreren ersten fotoelektrischen Umwandlungszellen (320, 1120, 1320) abgeschieden ist; und
eine oder mehrere zweite fotoelektrische Umwandlungszellen (160, 1160, 1360), die aus einem dritten Verbindungshalbleitermaterial bestehen, an die eine oder mehreren ersten fotoelektrischen Umwandlungszellen (320, 1120, 1320) über die Bondschicht (330, 1130, 1330) gebondet sind und auf einer Lichteinfallsseite der einen oder mehreren ersten fotoelektrischen Umwandlungszellen (320, 1120, 1320) in einer Lichteinfallsrichtung angeordnet sind,
wobei Bandlücken der einen oder mehreren ersten fotoelektrischen Umwandlungszellen (320, 1120, 1320) und der einen oder mehreren zweiten fotoelektrischen Umwandlungszellen (160, 1160, 1360) abnehmen, wenn sich die ersten und die zweiten fotoelektrischen Umwandlungszellen von der Lichteinfallsseite an eine hintere Seite in der Lichteinfallsrichtung annähern,
wobei, wenn eine Anzahl der einen oder mehreren zweiten fotoelektrischen Umwandlungszellen (160, 1160, 1360) eins ist, eine Bandlücke der Bondschicht größer als oder gleich der Bandlücke der einen zweiten fotoelektrischen Umwandlungszelle ist und wenn eine Anzahl der einen oder mehreren zweiten fotoelektrischen Umwandlungszellen (160, 1160, 1360) mehr als eins ist, die Bandlücke der Bondschicht größer als oder gleich der Bandlücke von mindestens einer der zweiten fotoelektrischen Umwandlungszellen (160, 1160, 1360) ist,
wobei die erste fotoelektrische Umwandlungszelle (320, 1120, 1320), die in der vordersten Seite in der Lichteinfallsrichtung unter der einen oder den mehreren ersten fotoelektrischen Umwandlungszellen angeordnet ist, eine InP-basierte fotoelektrische Umwandlungszelle ist,
wobei die zweite fotoelektrische Umwandlungszelle, die in der hintersten Seite in der Lichteinfallsrichtung unter der einen oder den mehreren zweiten fotoelektrischen Umwandlungszellen (160, 1160, 1360) angeordnet ist, eine GaAs-basierte fotoelektrische Umwandlungszelle ist und
wobei die Bondschicht aus GaInP oder GaPSb mit einer Zugverformung relativ zum InP-Substrat (110, 1110) besteht.

2. Verbindungshalbleiter-Fotovoltaikzelle (1101), umfassend:
ein Verbindungshalbleitersubstrat, das ein InP-Substrat (1110) ist;
eine oder mehrere erste fotoelektrische Umwandlungszellen (1120), die aus einem ersten Verbindungshalbleitermaterial bestehen und auf dem Verbindungshalbleitersubstrat abgeschieden sind;
eine Oberflächenschicht (1130A), die aus einem zweiten Verbindungshalbleitermaterial besteht und auf der einen oder den mehreren ersten fotoelektrischen Umwandlungszellen abgeschieden ist;
eine oder mehrere zweite fotoelektrische Umwandlungszellen (1160), die aus einem dritten Verbindungshalbleitermaterial bestehen, auf einer Lichteinfallsseite der Oberflächenschicht (1130A) und der einen oder den mehreren ersten fotoelektrischen Umwandlungszellen (1120) in einer Lichteinfallsrichtung abgeschieden sind und von der Oberflächenschicht (1130A) um einen Abstand getrennt sind; und
eine Nanopartikelanordnung (1102), die einen Schichtkörper aus der einen oder den mehreren ersten fotoelektrischen Umwandlungszellen (1120) und der Oberflächenschicht (1130A) an die eine oder mehreren zweiten fotoelektrischen Umwandlungszellen (1160) bondet,
wobei Bandlücken der einen oder mehreren ersten fotoelektrischen Umwandlungszellen (1120) und der einen oder mehreren zweiten fotoelektrischen Umwandlungszellen (1160) abnehmen, wenn sich die ersten und die zweiten fotoelektrischen Umwandlungszellen (1160) von der Lichteinfallsseite an eine hintere Seite in der Lichteinfallsrichtung annähern,
wobei, wenn eine Anzahl der einen oder mehreren zweiten fotoelektrischen Umwandlungszellen (1160) eins ist, eine Bandlücke der Oberflächenschicht (1130A) größer als oder gleich einer Bandlücke der einen zweiten fotoelektrischen Umwandlungszelle ist und wenn eine Anzahl der einen oder mehreren zweiten fotoelektrischen Umwandlungszellen (1160) mehr als eins ist, die Bandlücke der Oberflächenschicht (1130A) größer als oder gleich der Bandlücke von mindestens einer der zweiten fotoelektrischen Umwandlungszellen (1160) ist und
wobei die erste fotoelektrische Umwandlungszelle (1120), die in der vordersten Seite in der Lichteinfallsrichtung unter der einen oder den mehreren ersten fotoelektrischen Umwandlungszellen angeordnet ist, eine InP-basierte fotoelektrische Umwandlungszelle ist,
wobei die zweite fotoelektrische Umwandlungszelle, die in der hintersten Seite in der Lichteinfallsrichtung unter der einen oder den mehreren zweiten fotoelektrischen Umwandlungszellen (1160) angeordnet ist, eine GaAs-basierte fotoelektrische Umwandlungszelle ist,
wobei die Oberflächenschicht (130A) aus GaInP oder GaPSb mit einer Zugverformung relativ zum InP-Substrat (1110) besteht.

3. Verbindungshalbleiter-Fotovoltaikzelle (300, 400, 1100, 1103, 1200, 1300, 1400) nach Anspruch 1,
wobei die Bandlücke der Bondschicht größer als oder gleich einer Bandlücke der zweiten fotoelektrischen Umwandlungszelle, die an die Bondschicht auf der Lichteinfallsrichtung angrenzt, ist.

4. Verbindungshalbleiter-Fotovoltaikzelle (300, 400, 1100, 1103, 1200, 1300, 1400) nach Anspruch 1,
wobei die Bondschicht (330, 1130, 1330, 1330A) einen Tunnelübergang zwischen der einen oder den mehreren zweiten fotoelektrischen Umwandlungszellen (360, 1160, 1360) und der einen oder den mehreren ersten fotoelektrischen Umwandlungszellen (320, 1120, 1320) bildet, wobei die eine oder mehreren zweiten fotoelektrischen Umwandlungszellen (360, 1160, 1360) an die Bondschicht (330, 1130, 1330, 1330A) angrenzen und auf der Lichteinfallsseite der Bondschicht (330, 1130, 1330, 1330A) in der Lichteinfallsrichtung angeordnet sind, wobei die eine oder mehreren ersten fotoelektrischen Umwandlungszellen (320, 1120, 1320) an die Bondschicht (330, 1130, 1330, 1330A) angrenzen und auf der hinteren Seite der Bondschicht (330, 1130, 1330, 1330A) in der Lichteinfallsrichtung angeordnet sind.

5. Verbindungshalbleiter-Fotovoltaikzelle (300, 400, 1100, 1101, 1103, 1200, 1300, 1400) nach einem der Ansprüche 1 bis 4,
wobei die eine oder mehreren ersten fotoelektrischen Umwandlungszellen (320, 1120, 1320) eine Fensterschicht (324, 1124, 1324), die auf der Lichteinfallsseite in der Lichteinfallsrichtung angeordnet ist, beinhalten, wobei die Fensterschicht (324, 1124, 1324) eine Bandlücke größer als oder gleich einer Bandlücke einer zweiten fotoelektrischen Umwandlungszelle (360, 1160, 1360), die in der hintersten Seite in der Lichteinfallsrichtung unter der einen oder den mehreren zweiten fotoelektrischen Umwandlungszellen (360, 1160, 1360) angeordnet ist, aufweist.

6. Verbindungshalbleiter-Fotovoltaikzelle (300, 400, 1100, 1103, 1200, 1300, 1400) nach Anspruch 5,
wobei die Fensterschicht (324, 1124, 1324) aus einem von GaInP, GaPSb, Al(Ga)InAs, Al(Ga)AsSb, Al(Ga)PSb und Al(In)PSb besteht.

7. Verbindungshalbleiter-Fotovoltaikzelle (300, 400, 1100, 1101, 1103, 1200, 1300, 1400) nach einem der Ansprüche 1 bis 6,
wobei die eine oder mehreren zweiten fotoelektrischen Umwandlungszellen (1160, 1360) eine GaInAs-Zelle mit einer Druckverformung relativ zu einem GaAs-Substrat beinhalten.

8. Verbindungshalbleiter-Fotovoltaikzelle (300, 400, 1100, 1101, 1103, 1200, 1300, 1400) nach einem der Ansprüche 1 bis 7,
wobei die Verbindungshalbleiter-Fotovoltaikzelle (300, 400, 1100, 1101, 1103, 1200, 1300, 1400) eine Mehrfachzelle bestehend aus mindestens drei fotoelektrischen Umwandlungszellen, die optisch in Reihe in der Laminierrichtung gebondet sind, basierend auf der einen oder den mehreren ersten fotoelektrischen Umwandlungszellen (320, 1120, 1320) und der einen oder den mehreren zweiten fotoelektrischen Umwandlungszellen (360, 1160, 1360) ist.

9. Verbindungshalbleiter-Fotovoltaikzelle (300, 400, 1100, 1101, 1103, 1200, 1300, 1400) nach Anspruch 8, ferner umfassend:
eine auf GaAs- oder Ge-Gitteranpassung basierende Materialzelle, die (Al)GaInP(As) beinhaltet; und
eine auf InP-Gitteranpassung basierende Materialzelle, die GaIn(P)As beinhaltet.

10. Verbindungshalbleiter-Fotovoltaikzelle (1101) nach Anspruch 2, wobei die Bandlücke der Oberflächenschicht (1130A) größer als oder gleich einer Bandlücke der zweiten fotoelektrischen Umwandlungszelle (1160), die an die Oberflächenschicht (1130A) in der Lichteinfallsrichtung angrenzt, ist.

## Revendications

1. Cellule photovoltaïque à semi-conducteur composé (300, 400, 1100, 1103, 1200, 1300, 1400), comprenant :
un substrat de semi-conducteur composé étant un substrat d'InP (110, 1110) ;
une ou plusieurs premières cellules de conversion photoélectrique (320, 1120, 1320) faites d'un premier matériau de semi-conducteur composé et déposées sur le substrat de semi-conducteur composé (110, 1110) ;
une couche de liaison (330, 1130, 1330) faite d'un deuxième matériau de semi-conducteur composé et déposée sur les une ou plusieurs premières cellules de conversion photoélectrique (320, 1120, 1320) ; et
une ou plusieurs secondes cellules de conversion photoélectrique (160, 1160, 1360) faites d'un troisième matériau de semi-conducteur composé, liées aux une ou plusieurs premières cellules de conversion photoélectrique (320, 1120, 1320) par l'intermédiaire de la couche de liaison (330, 1130, 1330), et disposées sur un côté incident de lumière des une ou plusieurs premières cellules de conversion photoélectrique (320, 1120, 1320) dans une direction incidente de lumière,
dans laquelle des bandes interdites des une ou plusieurs premières cellules de conversion photoélectrique (320, 1120, 1320) et des unes ou plusieurs secondes cellules de conversion photoélectrique (160, 1160, 1360) diminuent lorsque les premières et secondes cellules de conversion photoélectrique se rapprochent, à partir du côté incident de lumière, d'un côté arrière dans la direction incidente de lumière,
dans laquelle, lorsqu'un nombre des unes ou plusieurs secondes cellules de conversion photoélectrique (160, 1160, 1360) est d'un, une bande interdite de la couche de liaison est supérieure ou égale à la bande interdite de l'une seconde cellule de conversion photoélectrique, et, lorsqu'un nombre des unes ou plusieurs secondes cellules de conversion photoélectrique (160, 1160, 1360) est plus d'un, la bande interdite de la couche de liaison est supérieure ou égale à la bande interdite d'au moins une des secondes cellules de conversion photoélectrique (160, 1160, 1360),
dans laquelle la première cellule de conversion photoélectrique (320, 1120, 1320), qui est disposée dans le côté le plus avant dans la direction incidente de lumière parmi les une ou plusieurs premières cellules de conversion photoélectrique, est une cellule de conversion photoélectrique à base d'InP,
dans laquelle la seconde cellule de conversion photoélectrique, qui est disposée dans le côté le plus arrière dans la direction incidente de lumière parmi les unes ou plusieurs secondes cellules de conversion photoélectrique (160, 1160, 1360), est une cellule de conversion photoélectrique à base de GaAs, et
dans laquelle la couche de liaison est faite de GaInP ou de GaPSb ayant une déformation due à la traction relativement au substrat d'InP (110, 1110).

2. Cellule photovoltaïque à semi-conducteur composé (1101), comprenant :
un substrat de semi-conducteur composé étant un substrat d'InP (1110) ;
une ou plusieurs premières cellules de conversion photoélectrique (1120) faites d'un premier matériau de semi-conducteur composé et déposées sur le substrat de semi-conducteur composé ;
une couche de surface (1130A) faite d'un deuxième matériau de semi-conducteur composé et déposée sur les une ou plusieurs premières cellules de conversion photoélectrique ;
une ou plusieurs secondes cellules de conversion photoélectrique (1160) faites d'un troisième matériau de semi-conducteur composé, disposées sur un côté incident de lumière de la couche de surface (1130A) et des une ou plusieurs premières cellules de conversion photoélectrique (1120) dans une direction incidente de lumière, et séparées de la couche de surface (1130A) par une distance ; et
un réseau de nanoparticules (1102) qui lie un corps en couches des une ou plusieurs premières cellules de conversion photoélectrique (1120) et la couche de surface (1130A) aux une ou plusieurs secondes cellules de conversion photoélectrique (1160),
dans laquelle des bandes interdites des une ou plusieurs premières cellules de conversion photoélectrique (1120) et les unes ou plusieurs secondes cellules de conversion photoélectrique (1160) diminuent lorsque les premières et secondes cellules de conversion photoélectrique (1160) se rapprochent, à partir du côté incident de lumière, d'un côté arrière dans la direction incidente de lumière,
dans laquelle, lorsqu'un nombre des une ou plusieurs secondes cellules de conversion photoélectrique (1160) est d'un, une bande interdite de la couche de surface (1130A) est supérieure ou égale à une bande interdite de l'une seconde cellule de conversion photoélectrique, et, lorsqu'un nombre des unes ou plusieurs secondes cellules de conversion photoélectrique (1160) est plus d'un, la bande interdite de la couche de surface (1130A) est supérieure ou égale à la bande interdite d'au moins un des secondes cellules de conversion photoélectrique (1160), et
dans laquelle la première cellule de conversion photoélectrique (1120), qui est disposée dans le côté le plus avant dans la direction incidente de lumière parmi les une ou plusieurs premières cellules de conversion photoélectrique, est une cellule de conversion photoélectrique à base d'InP,
dans laquelle la seconde cellule de conversion photoélectrique, qui est disposée dans le côté le plus arrière dans la direction incidente de lumière parmi les unes ou plusieurs secondes cellules de conversion photoélectrique (1160), est une cellule de conversion photoélectrique à base de GaAs,
dans laquelle la couche de surface (130A) est faite de GaInP ou de GaPSb ayant une déformation due à la traction relativement au substrat d'InP (1110).

3. Cellule photovoltaïque à semi-conducteur composé (300, 400, 1100, 1103, 1200, 1300, 1400) selon la revendication 1,
dans laquelle la bande interdite de la couche de liaison est supérieure ou égale à une bande interdite de la seconde cellule de conversion photoélectrique qui est adjacente à la couche de liaison sur la direction incidente de lumière.

4. Cellule photovoltaïque à semi-conducteur composé (300, 400, 1100, 1103, 1200, 1300, 1400) selon la revendication 1,
dans laquelle la couche de liaison (330, 1130, 1330, 1330A) forme une jonction à effet tunnel entre les unes ou plusieurs secondes cellules de conversion photoélectrique (360, 1160, 1360) et les une ou plusieurs premières cellules de conversion photoélectrique (320, 1120, 1320), les unes ou plusieurs secondes cellules de conversion photoélectrique (360, 1160, 1360) étant adjacentes à la couche de liaison (330, 1130, 1330, 1330A) et disposées sur le côté incident de lumière de la couche de liaison (330, 1130, 1330, 1330A) dans la direction incidente de lumière, les une ou plusieurs premières cellules de conversion photoélectrique (320, 1120, 1320) étant adjacentes à la couche de liaison (330, 1130, 1330, 1330A) et disposées sur le côté arrière de la couche de liaison (330, 1130, 1330, 1330A) dans la direction incidente de lumière.

5. Cellule photovoltaïque à semi-conducteur composé (300, 400, 1100, 1101, 1103, 1200, 1300, 1400) selon l'une quelconque des revendications 1 à 4,
dans laquelle les une ou plusieurs premières cellules de conversion photoélectrique (320, 1120, 1320) incluent une couche fenêtre (324, 1124, 1324) disposée sur le côté incident de lumière dans la direction incidente de lumière, la couche fenêtre (324, 1124, 1324) ayant une bande interdite supérieure ou égale à une bande interdite d'une seconde cellule de conversion photoélectrique (360, 1160, 1360), qui est disposée dans le côté le plus arrière dans la direction incidente de lumière parmi les unes ou plusieurs secondes cellules de conversion photoélectrique (360, 1160, 1360).

6. Cellule photovoltaïque à semi-conducteur composé (300, 400, 1100, 1103, 1200, 1300, 1400) selon la revendication 5, dans laquelle la couche fenêtre (324, 1124, 1324) est faite d'un quelconque de GaInP, de GaPSb, d'Al(Ga)InAs, d'Al(Ga)AsSb, d'Al(Ga)PSb, et d'Al(In)PSb.

7. Cellule photovoltaïque à semi-conducteur composé (300, 400, 1100, 1101, 1103, 1200, 1300, 1400) selon l'une quelconque des revendications 1 à 6,
dans laquelle les une ou plusieurs secondes cellules de conversion photoélectrique (1160, 1360) incluent une cellule de GaInAs ayant une déformation due à la compression relativement à un substrat de GaAs.

8. Cellule photovoltaïque à semi-conducteur composé (300, 400, 1100, 1101, 1103, 1200, 1300, 1400) selon l'une quelconque des revendications 1 à 7,
dans laquelle la cellule photovoltaïque à semi-conducteur composé (300, 400, 1100, 1101, 1103, 1200, 1300, 1400) est une cellule multi-jonction constituée d'au moins trois cellules de conversion photoélectrique, qui sont optiquement liées en série dans la direction de stratification, sur la base des une ou plusieurs premières cellules de conversion photoélectrique (320, 1120, 1320) et des une ou plusieurs secondes cellules de conversion photoélectrique (360, 1160, 1360).

9. Cellule photovoltaïque à semi-conducteur composé (300, 400, 1100, 1101, 1103, 1200, 1300, 1400) selon la revendication 8, comprenant en outre :
une cellule de matériau à base de correspondance de réseau de GaAs ou de Ge incluant (Al)GaInP(As) ; et
une cellule de matériau à base de correspondance de réseau d'InP incluant GaIn(P)As.

10. Cellule photovoltaïque à semi-conducteur composé (1101) selon la revendication 2, dans laquelle la bande interdite de la couche de surface (1130A) est supérieure ou égale à une bande interdite de la seconde cellule de conversion photoélectrique (1160) qui est adjacente à la couche de surface (1130A) dans la direction incidente de lumière.
